# EUROPEAN PATENT APPLICATION

(11) **EP 2 903 297 A1**
(43) Date of publication of application: **05.08.2015**
(21) Application number: 13842296.9
(22) Date of filing: 26.09.2013
(51) Int. Cl.: H04Q 9/00, G01R 11/00, H02J 3/00, H02J 13/00

(54) **SYSTEM FOR REMOTELY MONITORING HOUSEHOLD APPLIANCE**

(30) Priority: 27.09.2012 JP 2012214736
(71) Applicant: Nitto Denko Corporation, Ibaraki-shi, Osaka 567-8680 (JP)
(72) Inventor: HIEDA Yoshihiro, Ibaraki-shi Osaka 567-8680 (JP); BAN Naoki, Ibaraki-shi Osaka 567-8680 (JP); TSUTSUMIUCHI Ryoji, Ibaraki-shi Osaka 567-8680 (JP)
(74) Representative: Grünecker Patent- und Rechtsanwälte PartG mbB
(86) International application number: PCT/JP2013/076103
(87) International publication number: WO 2014/050985

(57) **Abstract**

The problem to be solved is to specify a connected electric household appliance at a power plug from a measurement result of power waveform, or the like, of each piece of electric equipment when power is distributed to a plurality of electric equipment, and to control an EoD system by measuring and calculating a request power amount of the electric household appliance and recognizing an operation state of each piece of electric equipment to detect abnormal operation. As a solution, an electric household appliance remote monitoring system comprised of a smart tap to which one or two or more power plugs of electric equipment can be inserted, an electric household appliance incorporating a smart tap function, and a server, the smart tap including voltage waveform measuring means and/or current waveform measuring means and communication means, the voltage waveform measuring means and the current waveform measuring means measuring a voltage waveform and a current waveform of power to be supplied to one or more pieces of electric equipment via the power plug connected to the voltage waveform measuring means and the current waveform measuring means, the communication means transmitting the voltage waveform and/or the current waveform or these waveforms to the server provided at a different place from a place where the tap is provided, the server having a function of judging an operation state of each piece of connected electric equipment based on the voltage waveform and/or the current waveform received from the smart tap and, when detecting abnormality of the electric equipment, transmitting the detection to an external network, is provided.

## Description

### Technical Field

The present invention relates to an electric household appliance remote monitoring system including a smart tap for an outlet, a tap, or the like, to which power plugs of various pieces of electric equipment and electric household appliances are connected.

### Background Art

A currently known system for supplying power to electric household appliance, intended to visualize power, reduce power consumption or manage power consumption will be described below.

There is publicly known as disclosed in Patent Literature 1, a home energy management system including: power amount measuring means for measuring current power consumption indicating a power amount currently consumed in a dwelling unit; upper limit power amount setting and storage means which is capable of setting and storing an upper limit power amount indicating a maximum amount of an overall power amount which can be consumed in the dwelling unit; power management means for sequentially calculating current allowable power consumption based on input of the upper limit power amount and the current power consumption; at least one or more pieces of performance control electric equipment operating while adjusting performance so as to control power consumption using the current allowable power consumption as an upper limit; and allowable power input means for sequentially inputting the current allowable power consumption to the performance control electric equipment, and the home energy management system further including: one or more pieces of performance control electric equipment capable of adjusting a power amount to be consumed by adjusting operating performance; one or more outlet adapters having an energization and shutoff control function; and one or more pieces of electric equipment connected to the outlets, and the power management means performing control of at least one or more among instructing the performance control electric equipment to adjust the operating performance and shutting off one or more pieces of equipment selected from equipment connected to the outlet having a shutoff function according to a predetermined algorithm.

It is also publicly known as disclosed in Patent Literature 1 that, when there are a plurality of pieces of performance control electric equipment, power is supplied after performance control electric equipment which is made to operate is determined according to allowable power consumption, or the operating performance of the performance control electric equipment is adjusted according to the allowable power consumption, and, in some cases, operation of other electric equipment is suppressed or cancelled.

There is publicly known as disclosed in Patent Literature 2, an electric quantity monitoring device which monitors power consumption of electric equipment connected to an outlet within a house or a factory, including: a table tap provided with a plurality of power plug insertion slots, the table tap being capable of connecting power plugs of a plurality of pieces of electric equipment to the outlet within the house or the factory; a current transformer built in the table tap, the current transformer detecting each current flowing to each piece of electric equipment connected to the outlet via the power plug insertion slots, and a voltage transformer commonly detecting a voltage; and a microcomputer built in the table tap, the microcomputer being capable of monitoring the detected current and voltage and electric quantity such as power consumption calculated based on the detected current and voltage and transmitting these monitoring information through the web for control to upper level server apparatuses or general-purpose personal computers through LAN connection.

There is publicly known as disclosed in Patent Literature 3, an energy saving control system including: a plug having a load side on which energy saving control is performed and an energy saving control side controlling an energy saving state of this load side, and the plug being connected to the load at the load side; and a power tap having a plurality of plug insertion slots into which the plugs are inserted, and the plug having a built-in IC tag into which load data is written, the power tap including: an IC tag reader obtaining load data by performing communication with the IC tag and current detecting means for detecting a current to be supplied to the plug inserted into the plug insertion slot, for each of the plug insertion slots; and a programmable controller unit processing communication data between the IC tag and the IC tag reader, and current detection data from the current detecting means, and transmitting the resultant to the above-described energy saving control side, and the above-described energy saving control side being capable of performing energy saving control based on the above-described data obtained through communication with the above-described programmable controller means.

There is publicly known as disclosed in Patent Literature 4, a power supply system including: a plurality of power supply connecting means to which load equipment is connected and which becomes a slave unit supplying power to the load equipment; and a display device connected to these power supply connecting means through signal lines and which becomes a master unit having a display unit for displaying a power consumption state of the power supply connecting means by receiving signals transmitted from the power supply connecting means, a unique address being assigned to each of the power supply connecting means, each of the power supply connecting means including: an address setting unit registering the own address to the display device; a current detecting unit detecting a current to be supplied to each of the power supply connecting means; and a transmitting unit transmitting a current value detected at the current detecting unit and the own address to the display device through the signal lines, the display device including: a receiving unit receiving a signal from each of the power supply connecting means and a calculating unit calculating the power consumption state of each of the power supply connecting means based on the current value detected at the current detecting unit, and, when the power integrated value exceeds a preset judgment value, or when the current value detected at the power supply connecting means exceeds a judgment value, power supply of the power supply connecting means is shut off.

There is publicly known as disclosed in Patent Literature 5, a power supply control device of a power tap having one or a plurality of power plug connecting means, the power supply control device including: standby power detecting means for detecting whether a supply power value to be supplied to the one or the plurality of power plug connecting means corresponds to a standby power value; and power supply stopping means for stopping power supply to each of the power plug connecting means after a predetermined period has elapsed after the above-described standby power detecting means detects that the supply power value corresponds to the standby power value.

Further, other than the systems disclosed in these patent literatures, a so-called smart meter is also known. The smart meter which is realized by making a conventional integrated power consumption meter provided at each house work online, is a device for measuring an integrated power amount consumed by one house for a certain period of time.

The above-described background arts are all techniques using outlets or table taps not embedded in the wall, and necessary measuring equipment and control devices are incorporated in the outlets or the table taps.

However, these techniques merely measure power consumption of connected electric equipment.

As one of the components of a so-called smart grid, introduction of an automatic power consumption measurement system for each home, or the like, and enabling power consumption of each home, or the like, to be measured online have been proceeding. Further, an outlet type meter has been commercialized for the purpose of measuring a power amount of each electric household appliance and a power supply. However, these are merely online electric energy meters, and merely measure an integrated power amount for a certain period of time and transmit the measurement value. In addition, these meters measure power consumption of the whole house at intervals of several tens of minutes.

In addition, a system in which, for operation of equipment, a threshold for indicating an abnormality degree is set based on operation information data learned in advance, and, if this threshold is exceeded, it is judged as abnormal and power supply to the equipment is stopped, is known as disclosed in Patent Literature 6 and Patent Literature 7.

### Citation List

### Patent Literature

Patent Literature 1: Japanese Patent Laid-Open No. 2008-104310
Patent Literature 2: Japanese Patent Laid-Open No. 2008-261826
Patent Literature 3: Japanese Patent Laid-Open No. 2011-010000
Patent Literature 4: Japanese Patent Laid-Open No. 2011-072099
Patent Literature 5: Japanese Patent Laid-Open No. 2011-078177
Patent Literature 6: Japanese Patent Laid-Open No. 2011-192097
Patent Literature 7: Japanese Patent Laid-Open No. 2009-236608

### Summary of Invention

### Technical Problem

When a so-called smart tap is used as an information terminal aimed at detecting and controlling energy consumed at one house, office building, collective housing, facility, hospital, tenant, factory, or the like, it is required to recognize electric household appliance through a voltage waveform and a current waveform of each electric household appliance and measure and display usage states and power consumption, as well as measure a power amount of each electric household appliance, electric equipment and a distributed power supply and display the measurement results.

Further, between each electric household appliance and electric equipment and a power supply (power grid, renewable energy, or a rechargeable battery), it is required to recognize each electric household appliance as to which electric household appliance and electric equipment are used in real time, measure total power consumption regarding how much power amount is requested, and measure a requested power amount for each electric household appliance and electric equipment among the total power consumption.

In the conventional system for visualizing power usage states and total power consumption, in order to save power, a user needs to consciously control himself to often manually turn off each electric household appliance, or the like, or adjust time for using equipment so that the equipment is not used at the same time. It is therefore desired to enable power saving and cutting peak power usage while maintaining quality of life and making the user as little aware of power saving as possible.

It is desired to utilize the information of the energy usage states to learn and recognize a pattern of behavior of the user, that is, usage patterns of the electric household appliance, and finely control the power consumption within the house in real time. To achieve this, it is required to connect the electric household appliance, measure detailed voltage and current waveforms, or the like, and measure, collect, calculate, control and communicate a power amount for each outlet, that is, for each connected electric household appliance, and, further, combine these to estimate and control power flow for each house or for each group of a plurality of houses.

Moreover, in a system of energy on demand, that is, EoD (hereinafter, referred to as "EoD"), it is required to provide a pair of power supplies including a commercial power supply to the above-described each group of the plurality of houses and judge from which power supply how much power is to be supplied among the plurality of power supplies provided within one group. Therefore, a problem of the EoD system is to specify electric household appliance connected to a power plug from the measurement results of the power waveform of each piece of electric equipment when a plurality of pieces of electric equipment are energized, and further, to recognize operation states of the electric equipment using a simple device to detect abnormal operation and control the EoD system.

It should be noted that in the case of, for example, a house and collective housing, other than a problem of reducing power of electric household appliance, there is a problem that it is required to remotely monitor electric household appliance by utilizing a function of recognizing electric household appliance to instantaneously detect abnormality of electric household appliance, such as electricity leakage, displaying the abnormality, notifying the user of the abnormality and also making this system coordinate with external servers or cloud.

### Solution to Problem

According to an electric household appliance remote monitoring system of the present invention, by measuring power flow itself of power consumption and distribution of one or a plurality of power sources and its power network, and electric household appliance on the power network, a power supply pattern such as a voltage waveform and a current waveform of the connected electric household appliance is compared with an original power waveform of each electric household appliance which is measured in advance and stored in a server, so that it is detected whether the electric household appliance used in the house normally operates or degrades, or some abnormality occurs.

Further, based on such detection results, the user can confirm that the electric household appliance normally operates, and it is also possible to provide information regarding repair and updating of the electric household appliance, and further, a way of using the electric household appliance to the user or the owner of the electric household appliance as necessary.

Still further, for example, it is also possible to control power consumption so as to fall within a range at which the overall electric household appliance operates without posing an obstacle to daily life by setting priorities to usage of each electric household appliance in the house based on the overall power usage state.

Specifically, the present invention provides as follows.
1. An electric household appliance remote monitoring system comprised of a smart tap to which one or two or more power plugs of electric equipment can be inserted, and a server,
   the smart tap including voltage waveform measuring means and/or current waveform measuring means, communication means, and, optionally, computing means,
   the voltage waveform measuring means and the current waveform measuring means measuring a voltage waveform and a current waveform of power to be supplied to one or more pieces of electric equipment via the power plug connected to the voltage waveform measuring means and the current waveform measuring means,
   the communication means transmitting any one or more of the voltage waveform, the current waveform, a characteristic amount of the voltage waveform, a characteristic amount of the current waveform, and, optionally, a waveform of a power amount and a characteristic amount of the waveform of the power amount to the server provided at a different place from a place where the tap is provided,
   the computing means provided optionally obtaining the waveform of the power amount based on the voltage waveform and the current waveform,
   the server storing any one or more of the voltage waveform, the current waveform, the characteristic amount of the voltage waveform, the characteristic amount of the current waveform, and, optionally, the waveform of the power amount and the characteristic amount of the waveform of the power amount received from the smart tap, and comparing any one or more of the newly measured and received voltage waveform, current waveform, characteristic amount of the voltage waveform, characteristic amount of the current waveform, and, optionally, a waveform of a power amount and a characteristic amount of the waveform of the power amount with the stored data to judge an operation state of each connected piece of electric equipment and transmit the operation state of the electric equipment.
2. The electric household appliance remote monitoring system according to item 1, wherein the server is a local server and transmits the judged operation state of the electric equipment to a global server using communication means separately provided.
3. The electric household appliance remote monitoring system according to item 2, wherein the operation state of the electric equipment is transmitted from the global server to a management server.
4. The electric household appliance remote monitoring system according to item 2 or 3, wherein information regarding repair or upgrading of the electric equipment and/or a way of using the electric equipment is transmitted to a user and/or an owner of the electric equipment based on the operation state of the electric equipment received at the global server or the management server.
5. The electric household appliance remote monitoring system according to item 1, wherein the server is a global server, can perform communication with the smart tap via a local server, and transmits the judged operation state of the electric equipment to the local server.
6. The electric household appliance remote monitoring system according to item 5, wherein any one or more of the voltage waveform, the current waveform, the characteristic amount of the voltage waveform, the characteristic amount of the current waveform, and, optionally, the waveform of the power amount and the characteristic amount of the waveform of the power amount, and/or the judged operation state of the electric equipment is transmitted from the global server to a management server.
7. The electric household appliance remote monitoring system according to item 2 or 3, wherein information regarding repair or upgrading of the electric equipment and/or a way of using the electric equipment is transmitted to a user and/or an owner of the electric equipment based on any one or more of the voltage waveform, the current waveform, the characteristic amount of the voltage waveform, the characteristic amount of the current waveform, and, optionally, the waveform of the power amount and the characteristic amount of the waveform of the power amount received at the global server or the management server, and/or the judged operation state of the electric equipment.

### Advantageous Effects of Invention

A main advantage of the present invention is that it is possible to judge whether the electric household appliance normally operates, whether degradation proceeds, or whether some abnormality occurs, and it is possible to notify the user of the information and transmit the information to an external network, and, therefore, abnormality of the electric household appliance is not left in a state where the user is not aware of the abnormality.

When the cause of the abnormality is, for example, electricity leakage, or the like, it is possible to stop power supply to the electric household appliance at which abnormality has been detected to eliminate possibility of a fire.

When degradation of the electric household appliance, abnormality such as failure, electricity leakage, or the like, are detected, to solve such problems, it is possible to transmit information regarding repair and updating of the electric equipment, and a way of using the electric equipment to the user and/or the owner of the electric equipment.

For example, when a company selling electric household appliance, such as an electric household appliance mass retailer, an electric household appliance online dealer, and a mail-order company makes a contract with the user and/or the owner of the system, because a state of the electric household appliance, that is, whether the electric household appliance operates normally or abnormally can be detected in real time at the external network, it is possible to remotely monitor and watch for the electric household appliance.

That is, by comparing the normal power waveform pattern and the characteristic amount of the electric household appliance with the power waveforms and the characteristic amounts upon the previous usage accumulated and stored in a database, if the waveform does not match the previous waveforms, it is possible to detect abnormality of wiring or an outlet or failure or trouble of the electric household appliance and provide repair and maintenance service to the user in advance.

Further, in companies selling electric household appliance such as an electric household appliance mass retailer, by combining existing customer data, that is, data such as purchase date and time, a type of a product, a manufacturer and a guarantee period with data of the system, it is possible to provide courteous service which makes the customer free from anxiety, by providing, for example, a guarantee period for the repair and introduction of new electric household appliance, to the user of the electric household appliance. Further, to an energy saving-minded customer, it is possible to introduce energy saving electric household appliance or introduce photovoltaic generation or a rechargeable battery which are to be used in combination with the system.

Still further, because the information of the electric household appliance during normal operation can be always monitored in real time, data such as a daily behavior pattern can be built from the information regarding usage or a usage pattern of the electric household appliance of the user, so that it is possible to implement a safety and security monitoring function.

A smart tap used in the present invention may take any form including an embedded outlet embedded in a wall portion, a ceiling portion, a floor portion, or the like, of a house, and a tap connected to the embedded outlet or a tap.

However, when the embedded type smart tap is used and an amount of heat generation of the smart tap is decreased, the whole surface of the box of the smart tap does not have to be formed with a metal which has high thermal conductivity such as aluminum to achieve heat dissipation. Therefore, in the smart tap embedded in the wall of a building, or the like, because radio waves can pass through the tap box without the need of a metal heat dissipation plate being provided outside a resin chassis, it is possible to perform communication with outside using the communication means provided within an outlet box without the need of shielding radio waves of the communication means.

Further, it is also possible to use electric household appliance incorporating a smart tap function which is substantially mounted, held or formed by a circuit achieving the smart tap function being connected within the electric household appliance without providing an outlet portion to which a power cord of the electric household appliance is to be connected. At this time, if there is extra space within the electric household appliance, there will be more flexibility as to where the circuit for achieving the smart tap function should be displaced.

### Brief Description of Drawings

[Figure 1] Figure 1 illustrates voltage and current waveforms of a hair dryer and a vacuum cleaner.
[Figure 2] Figure 2 is a layout of embedded outlets and taps for an on-demand power control system in a building.
[Figure 3a] Figure 3a illustrates a result of control according to the present invention seen from transition of power consumption.
[Figure 3b] Figure 3b illustrates a result of control according to the present invention seen from transition of power consumption.
[Figure 4] Figure 4 is a schematic diagram illustrating a structure of a smart tap of the present invention.
[Figure 5] Figure 5 illustrates a state where the present invention is implemented while a plurality of power supplies are used.
[Figure 6] Figure 6 is a layout of each means of the present invention.
[Figure 7] Figure 7 is another layout of each means of the present invention.
[Figure 8] Figure 8 is still another layout of each means of the present invention.
[Figure 9] Figure 9 is a flowchart of the present invention.
[Figure 10] Figure 10 is a flowchart for judging whether or not an electric household appliance operates normally in the present invention.
[Figure 11] Figure 11 is a diagram of an overall electric household appliance remote monitoring system of the present invention.
[Figure 12] Figure 12 is a schematic diagram of embodiments in which a fan is used.

### Reference Signs List

- 1: MOSFET
- 2: Current measuring means
- 3: Arithmetic device
- 4: Communication means
- 5: Circuit board for arithmetic device power supply
- 6: Front face
- 7: Substrate
- 8: Chassis
- 9: Substrate
- 10: Substrate
- 11: Control device

### Description of Embodiments

An electric household appliance remote monitoring system of the present invention which is a system basically detecting progress in degradation of connected electric household appliance or abnormality such as failure and electricity leakage, can be also used as an on-demand power control system (EoD system) in a home network. The system is an on-demand power control system in which an upper limit value of power consumption within a certain period of time or in a moment is defined, and control is performed to supply power preferentially to electric household appliance and electric equipment (hereinafter, collectively referred to as "electric household appliance") having higher priorities for the user so as not to detract quality of life of the user while a demand side is controlled to be within the upper limit value. Because the system controls operation of the electric household appliance in response to a result of detecting that the electric household appliance operates abnormally, the system includes a home server (hereinafter, referred to as a "server") separately provided as described above.

This system is intended to completely switch a "push type" (or demand response type) power network which is driven by a power supplier to a "pull type" (on-demand type) power network which is driven by a power consumer side such as a user and a consumer. In one or two or more houses, the system performs control in response to a result as to whether various electric household appliance operates normally, and stops the operation if the electric household appliance operates abnormally.

Further, in response to requests for power supply to various electric household appliance, for example, requests for power supply to an air conditioner, lighting, or the like, the system can also perform control to supply power preferentially to important electric household appliance having higher priorities (hereinafter, referred to as "dynamic priority control of electric household appliance") by the server analogizing "which request for power supply to the electric household appliance is the most important" from a usage pattern of the user.

The largest advantage obtained by using the above-described EoD system is that it is possible to enable energy saving and reduction in CO₂ emissions from a demand side. For example, if the user gives to the home server, an instruction to reduce electricity prices of a certain period of time or reduce power amount of a certain period of time by 20% in advance, this approach by the user can be realized through dynamic priority control of the electric household appliance by reducing power flowing by 20%, so that a system can realize energy saving and reduce CO₂ emissions.

Further, the user may optionally set priorities of the electric household appliance, or can set the priorities through a preset program according to seasons, climates, temperature, humidity, time, or the like. Further, this EoD system can automatically determine electric household appliance to which power should be preferentially supplied as appropriate based on a plan or an upper limit of power to be supplied and supply power to each electric household appliance based on the priorities of the electric household appliance from the result. Further, in addition to the plan and the upper limit of the power to be supplied, by learning a behavior pattern of the user, it is possible to build a power usage model and determine the priorities of the electric household appliance according to this model.

In these cases, it is possible to realize a control system which can build the power usage model and set a power usage plan based on the plan and the upper limit of power supply, the life pattern of the user and the life pattern of the user obtained through learning, and, with respect to these, measure, compare and calculate an instant peak power value in real time so as not to exceed a peak power value when power values are integrated.

Such an EoD system basically calculates a power amount (requested by the electric household appliance) required in real time for each electric household appliance, that is, a requested power amount, inside the outlet or the tap from a voltage waveform, a current waveform, a voltage value and a current amount of power supplied to the electric household appliance connected to the outlet and the tap. Moreover, the requested power amount is measured at an extremely high sampling rate which will be described below. The measurement results are computed at an arithmetic device inside the outlet or the tap and recognized and analyzed as patterns of the voltage waveform and the current waveform.

The voltage waveform and the current waveform of the power to be supplied to each electric household appliance often have patterns different for each electric household appliance. That is, presently, because the electric household appliance includes a control device such as a switching power supply and an inverter, a characteristic waveform appears for each electric household appliance in the current waveform within one AC cycle. Therefore, even for the same power consumption, the voltage and the current waveforms are often different from each other, which makes it possible to identify the electric household appliance connected to the outlet and the tap and detect an operation state of each electric household appliance and occurrence of abnormality such as degradation, failure and electricity leakage by compiling a database of patterns of these voltage and current waveforms in a server, or the like.

The voltage waveform, the current waveform, the characteristic amount of the voltage waveform, the characteristic amount of the current waveform, and, optionally, the waveform of the power amount and the characteristic amount of the waveform of the power amount measured at each smart tap are transmitted to the server, and the server judges the operation state of each electric household appliance, that is, which electric household appliance is operating, which electric household appliance is now powered on, and among them, which electric household appliance normally operates, and which electric household appliance does not normally operate or degrades.

To perform such judgment, the past voltage waveform, current waveform and power waveform and the characteristic amounts of these waveforms of the connected electric household appliance accumulated in the server are compared with the voltage waveform, the current waveform, the power waveform and the characteristic amounts of these waveforms of the same electric household appliance when the electric household appliance is powered on again.

By comparing the newly measured voltage and current waveforms with the past voltage and current waveforms, a peak value of the voltage or the current in the characteristic amount of the electric household appliance, a cycle of the peak value, a vector of change in the voltage and the current at a reference time point within the cycle, or the like, are compared. Further, it is judged whether the current required by the electric household appliance tends to increase, whether the electric household appliance tends to require power more than standby electricity during an OFF state, or whether the electric household appliance tends to be delayed in starting operation after the electric household appliance is powered on, or the like.

As a result of these judgments, when these tendencies are obviously noticeable compared to when the electric household appliance was installed, it is judged that the electric household appliance degrades, or failure or electricity leakage occurs, and the results are displayed or control is performed to stop power supply to the electric household appliance. It is also possible to directly notify an organization, a store, or the like, which maintains, inspects or replaces the electric household appliance of these results.

Further, judgment is performed based on the requested power amount, a power amount which can be supplied, the priorities of the electric equipment, or the like, and a signal for controlling an amount of power to be supplied to each electric household appliance is transmitted as appropriate to each smart tap. This transmission can be performed through packet communication, or the like.

Each smart tap receives packets and controls power supply to the connected electric household appliance based on the instruction. It is therefore possible to put the electric household appliance which has been just powered on into a standby state until the next instruction for power supply is received instead of starting operation, or put the electric household appliance which is operating into an OFF state or reduce or increase power to be supplied to the electric household appliance which is operating.

It should be noted that, in the present invention, whether or not the electric household appliance operates normally may be judged at any server of a local server which directly performs communication with each smart tap and a global server which directly performs communication with a plurality of local servers via the local server, and the server of the present invention includes these two types of servers.

The present invention will be described below.

The smart tap of the present invention is a device to which a power plug of the electric household appliance is directly connected and which can supply power to the electric household appliance, and may be a device which is a smart tap such as a so-called table tap and is used by being connected to an outlet embedded in the wall surface, or the like, of a building, or may be an embedded outlet embedded in the wall surface, a column, ceiling or floor of a building, or a structure such as furniture. The smart tap has one, two or three or more slots, and the shape of the smart tap is not particularly limited. The electric household appliance connected to the outlet and the tap includes electric household appliance used at home or collective housing, and electric equipment provided at office, building, tenant, hospital, business office, or the like.

Further, it is also possible to connect a plurality of electric household appliance to the table tap by connecting a tap, or the like, for branching the conventional so-called table tap or an outlet having two or more slots to the smart tap of the present invention. Also, in this case, it is possible to individually detect and control the electric equipment via the smart tap to which the connected plurality of electric household appliance are directly connected.

Further, it is also possible to further connect the smart tap of the present invention having two or more slots to the smart tap of the present invention, in which case, each smart tap can be made to operate or any one of the smart taps can be made to operate. Further, the smart tap of the present invention includes a circuit achieving a smart tap function embedded in the electric household appliance in addition to the forms of the above-described table tap and the outlet. In the case of utilizing the above-described electric household appliance incorporating the smart tap function, the electric household appliance does not include an outlet portion to which the power cord of the electric household appliance is connected and incorporates a smart tap function, by substantially including, holding or connecting a circuit achieving the smart tap function within the electric household appliance. If there is extra space within the electric household appliance, there will be more flexibility as to where the circuit for achieving the smart tap function should be displaced.

In the electric household appliance incorporating the smart tap function, the circuit for achieving the smart tap function is provided between the power supply circuit of the electric household appliance and the power cord which is to be connected to the outlet.

Voltage waveform measuring means in the embedded type smart tap of the present invention may be publicly known measuring means for performing control which measures a voltage waveform in real time, and optional general-purpose measuring means can be employed as long as the measuring means can be held within the embedded type smart tap in a similar manner as the current waveform measuring means.

Current measuring means for measuring a current waveform and power consumption, which can be used in the embedded type smart tap of the present invention may be publicly known measuring means for performing control which measures a current waveform in real time, and general-purpose measuring means such as, for example, CT, shunt and a Rogwskii coil, can be employed as long as the measuring means can be held within the embedded type smart tap.

Further, means for obtaining the power amount is computing means for obtaining the power amount based on the measured current and the measurement value of the voltage.

The communication means of the present invention is basically means for transmitting to a server provided at another place, various data in the EoD system which will be described later, such as a voltage waveform, a current waveform, a current waveform obtained by processing the voltage waveform and the current waveform, data of the characteristic amount such as a peak value of these waveforms, and, further, an attribute of the electric household appliance to which the power plug is connected, and power consumption calculated at the arithmetic device, and a request power message when the electric household appliance is powered on, and receiving data required for controlling the electric household appliance obtained through mediation at the server, that is, a power allocation message for the electric household appliance which is powered on and which requests power supply, the power allocation message being a result of computing the priorities of power supply to each electric household appliance including other electric household appliance which is operating and the requested power amount.

This communication may be performed through packet communication and is performed at an arbitrary timing.

The communication means can include an oscillation circuit such as a crystal oscillator.

As such communication means, a ZigBee module (of, for example, 2.4 GHz, 920 MHz, or the like) can be employed, and other publicly known wireless communication means such as Z-wave, Bluetooth (R), DECT (of a band of 1.9 Hz), an ultrahigh frequency of a band of 950 MHz can be also employed.

Further, PLC, or the like, can be also utilized as wired communication means other than the wireless communication means.

While the communication speed is low if the communication means complies with the ZigBee specification, the communication means can be made to serve as a repeater with respect to other smart taps by utilizing a mesh-type or star-type network relay function which is a characteristic of this specification. Therefore, the network can be flexibly expanded, and data can be reliably transmitted to and received from the server by self-restoring characteristics with respect to a fault in the communication path due to failure. Further, there is an advantage that because power consumption is extremely small, even if the communication means is provided at all the outlets in the building, the total power consumption is also extremely small.

In the smart tap of the present invention, the communication means is preferably displaced at an inner side of a panel which is formed with a material not blocking radio waves, such as a resin, on the front surface of the smart tap, so as to be aligned to the outlet, particularly, when wireless communication means is employed. When the smart tap is embedded in the wall, or the like, because the front surface of the smart tap faces the inside of the room, communication data transmitted from the wireless communication means is directly directed to the inside of the room, which makes it possible for the communication data to reliably reach the server, or the like, and, adversely, makes it possible for signals transmitted from the server, or the like, to be received at the wireless communication means facing the inside of the room more reliably.

The control means in the electric household appliance remote monitoring system of the present invention is means for controlling the power amount to be supplied for each electric household appliance through processing in the arithmetic device in response to signals of the result computed at the server and the information judged by the server that the electric household appliance operates abnormally, and switching power to be supplied to the electric household appliance and controlling the power amount to be supplied. It should be noted that switching of power to be supplied means stopping or starting power supply to the electric household appliance. Particularly, when it is detected that the connected electric household appliance does not normally operate, the control means can promptly stop power supply to the electric household appliance.

In the smart tap of the present invention, a semiconductor relay, particularly, MOSFET performing phase control is used. Because the flow of power to be supplied differs depending on the connected electric household appliance, it is possible to provide four to eight semiconductor devices considering that at least one or two or more semiconductor devices can be provided for each slot to which a power plug of an outlet or a tap is connected because commercial power is AC, according to an on resistance value of the semiconductor device. Because the maximum power consumption of generally used domestic electric household appliance is 1500 W and the voltage of a typical outlet is 100 V in Japan, the amount of heat dissipation of the control means is as follows given that a current up to 15 A flows through one outlet. It should be noted that in a case of an outlet for 200 V in Japan or in a country or region other than Japan where the voltage of the outlet is, for example, 200V, a current up to 7.5 A flows.

As the semiconductor device, a triac, MOSFET, or non-zero crossing means such as an SSR (Solid State Relay) can be utilized.

Particularly, MOSFET requires a small amount of power to control the power amount, and, thus, has a small amount of heat dissipation. MOSFET is more preferable than the triac in terms of the amount of heat dissipation. While because on resistance of the triac is 0.1 Ω, the amount of heat dissipation of the triac is 23.25 W in the case of 15 A, 1.5 KW, the amount of heat dissipation of MOSFET, for example, in the case where on resistance is 0.038 Ω, is 2.1 W, which is obviously smaller than that of the triac.

As MOSFET, Si, SiC, GaN, or the like, can be used, and further, MOSFET having lower on resistance is preferable.

Further, even if a power plug of the electric household appliance requiring larger power flow is connected to the smart tap, because the power control device has low resistance, the smart tap is not heated too much by way of these means, so that it is possible to provide parts, or the like, using a heat-sensitive crystal oscillator within the outlet, and perform control of power supply to the electric household appliance which requires such large power flow. As a result, if power is supplied to all the electric household appliance and electric equipment within the building via the smart tap, it is possible to control operation of them by way of a power supply to which power plugs are connected.

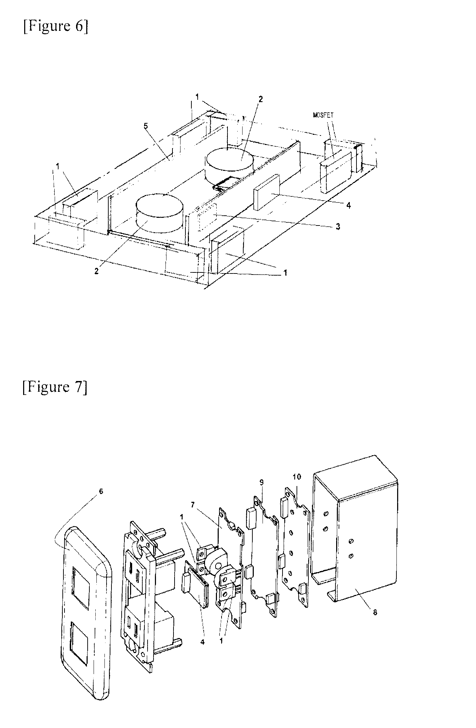

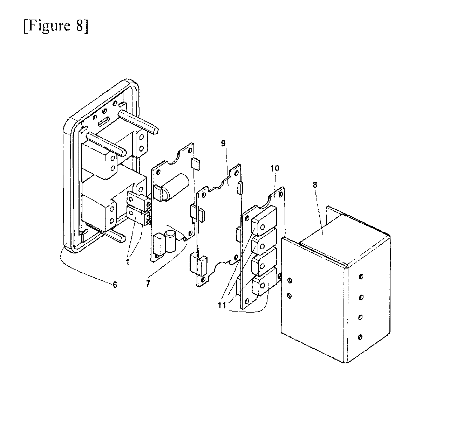

It should be noted that if the embedded type smart tap employs a smart tap structure (Figures 7 and 8) for improving communication performance of the communication means, it is possible to improve communication performance without causing communication inhibition because there is no metal part on the communication means. Therefore, in the smart tap structure illustrated in Figures 7 and 8, the rear surface of the chassis on an opposite side of the front surface to which the plug is inserted can be replaced with a metal chassis having high heat dissipation, so that heat of MOSFET which is a cause of heat generation, can be dissipated to the metal chassis via an insulating heat dissipation member, and the temperature within the tap can be maintained at 80°C or 70°C or less. By this means, it is possible to enable utilization of MOSFET other than MOSFET having low heat dissipation, that is, MOSFET having low on resistance.

Control by these semiconductor devices commonly has an advantage of high response speed, and is extremely effective when power to be supplied to the electric household appliance is controlled, and if response speed is desired to be as high as possible. However, if high response speed is not desired, it is also possible to employ a semiconductor relay or a mechanical relay as the control means. For example, it is possible to employ a mechanical relay when there is enough time for controlling other electric household appliance, for example, when the electric household appliance to which power is newly required to be supplied does not require much power for a predetermined time period after operation is started and the mechanical relay can control power supply to other electric household appliance for the predetermined time period. Because when the mechanical relay is used, the amount of heat dissipation is small as with the case where the MOSFET is used, thermal influence on the arithmetic device and the communication means is small.

In the computing means and/or the server of the present invention, the electric household appliance connected to the outlet is recognized based on the voltage waveform, the current waveform, the characteristic amount of the voltage waveform, the characteristic amount of the current waveform, and, optionally, the waveform of the power amount and the characteristic amount of the waveform of the power amount.

It should be noted that the computing means can calculate an effective power amount, that is, power consumption and a requested power amount from an effective current and an effective voltage obtained through measurement of the current waveform and measurement of the voltage waveform.

The electric household appliance connected to the outlet can be recognized before the electric household appliance is powered on, for example, when the electric household appliance is connected to the outlet, or the electric household appliance may not be recognized until the electric household appliance is powered on after the electric household appliance is connected to the outlet.

At this time, the smart tap measures the power waveform 0.1 or 0.5 seconds to 2 seconds immediately after the connected electric household appliance is powered on and transmits the measurement result to the server, and the server checks the measured power waveform against the power waveform registered in the server in advance, thereby it is possible to specify the electric household appliance which is powered on.

Here, any one or more of the current waveform and the voltage waveform of the connected electric household appliance and the characteristic amounts of the current waveform and the voltage waveform are stored in the server, and the current waveform and the voltage waveform of the electric household appliance regularly acquired or newly acquired when the electric household appliance is powered on and the characteristic amounts of the current waveform and the voltage waveform are compared with the stored characteristics.

Then, power may be supplied to the electric household appliance as is, or the electric household appliance may be powered off, and power to be supplied may be computed within the server while the electric household appliance is powered off, and transmitted to the smart tap, so that the smart tap can execute power supply to the electric household appliance or stop power supply to the electric household appliance.

It should be noted that, in the case where the electric household appliance is recognized when the electric household appliance is connected to the outlet, thereafter, the smart tap can perform control extremely promptly when the electric household appliance is powered on. Meanwhile, in the case where the connected electric household appliance is recognized when the electric household appliance is powered on, it takes slight time for the smart tap to start controlling the electric household appliance after the electric household appliance is powered on.

Further, the control means has a function of transmitting a computed signal to MOSFET, or the like controlling power supply to the outlet to which the electric household appliance is connected based on a voltage control signal and a current control signal as a supply message obtained from the server via the communication means.

It should be noted that the server performs computation of a requested power amount for each electric household appliance and computation to mediate power which can be supplied from a single or a plurality of power supplies, and controls power supply to the electric household appliance based on the priorities of the electric household appliance so as to save power and cut peak power usage for each house, or the like. The server can stop or interrupt operation of the electric household appliance which is operating, or reduce power supplied to the electric household appliance, or increase power supply.

As a result, it is possible to supply power requested by the electric household appliance which is just powered on or supply power of only a certain degree of requested power, or make the operation of the electric household appliance wait for a subsequent timing at which control is performed instead of supplying requested power.

Confirmation as to whether the connected electric household appliance normally operates may be performed at any arbitrary time point including when the electric household appliance is specified at the server, and when power is supplied to the connected electric household appliance, and after power is started to be supplied.

However, according to types of the electric household appliance, whether the connected electric household appliance normally operates may be confirmed at the server immediately after the electric household appliance starts operation and when the electric household appliance reaches a state where the operation of the electric household appliance gets settled after a certain period of time has elapsed since the electric household appliance started operation.

Here, in terms of life of parts of the smart tap, the ambient temperature of the microcomputer is favorably 80°C or lower, and in terms of life of the communication means, the amount of heat generation of MOSFET is preferably 8 W or lower.

Further, when the communication means is provided at a rear side of the panel formed with a non-metal material such as a resin which does not cause communication inhibition, on a front face at a side where a plug is inserted, the heat generating part ofMOSFET has a structure such that heat can be dissipated to a metal chassis (such as Al), a metal heat sink, or the like, at a rear side opposite to the front face of the outlet through an insulating heat dissipation material, heat dissipation sheet and heat dissipation adhesive sheet. Meanwhile, when the outlet front face member is formed with a metal member that causes communication inhibition, in order to incorporate the communication means in the smart tap, particularly, in order to suppress decrease in communication performance, a chassis formed with a non-metal such as a resin is selected. Therefore, because the heat generation ofMOSFET becomes worse than a case where the above-described metal chassis is employed, the amount of heat generation ofMOSFET is preferably 1 W or lower.

That is, in terms of life of a product and safety of the smart tap, to make the heat generation of the electric control device 80°C or lower, it is possible to employ a parallel connection structure which reduces a current introduced to each MOSFET or a serial connection structure (that is, two electric control devices for one outlet) which does not reduce introduced power.

Further, a heat dissipation plate which does not affect the communication means can be provided inside the device instead of being provided at the chassis of the smart tap itself, or the electric control device can be connected to the chassis via an insulating heat dissipation sheet taking into account heat dissipation resulting from the chassis of the smart tap being formed with a metal as will described below.

Particularly, as described above, when the communication means is displaced at the inner side of the front panel formed with a material such as a resin of the smart tap, through which radio waves can pass, because the communication means can perform communication through radio waves passing through the panel, the chassis of the smart tap can be formed with a metal which does not transmit radio waves.

At this time, because the metal chassis also serves as a heat dissipation plate, the control means such as FET can be connected to the chassis via a publicly known heat dissipation material such as an insulating heat dissipation sheet (for example, 0.5 to 20 W/mK). As a result, heat generated by the control means can be dissipated to the environment from the chassis through the insulating heat dissipation sheet. In this case, a fin, or the like, for heat dissipation can be provided outside the chassis. It should be noted that a resin formed with an insulating high thermal conductive resin composite material such as BN and ALN can be used as a chassis in place of the metal chassis.

Therefore, even if the amount of heat generation of one control means is approximately 8 W, heat is dissipated to the outside of the smart tap from the chassis, so that it is possible to prevent increase of the temperature of the communication means.

Accordingly, the communication means which measures power and transmits current and voltage waveforms is provided at the rear side of the panel formed with a resin material on the front face at a side of the smart tap to which a plug is inserted. In this case, because the surrounding of the receiving part of the communication device is formed with a non-metal material, communication performance does not degrade. Meanwhile, the heat generating part of the electric control device which is provided further behind the communication device, dissipates heat to the metal chassis or the metal heat sink through the insulating heat dissipation member (sheet, adhesive sheet), so that it is possible to maintain the temperature inside the smart tap and the chassis at 80°C or lower. That is, it is possible to suppress heat generation without degrading communication performance of the tap, and use an inexpensive device instead of an electric control device having small on resistance without shortening life of each device of the tap.

Further, as a structure of the smart tap, when the communication means is provided on the rear side formed with a non-metal resin which does not degrade communication performance of the communication means as described above, and the electric control device is provided behind the communication means, it is possible to utilize a high thermal conductivity resin composite material which has high thermal conductivity and also has insulation property and provide the heat generating part and this insulating high thermal conductivity resin chassis across the insulating heat dissipation member.

By this means, it is possible to reduce heat generation without degrading communication performance and use an inexpensive control device.

As described above, the communication device can be provided inside the smart tap, particularly, at a portion where communication is less likely to be inhibited, such as a metal, and, for example, in a structure where the communication device is provided at a lateral side, the chassis is formed with a resin which is less likely to cause communication inhibition. Therefore, as the electric control device, by selecting a device whose amount of heat generation is small, that is, which has a small on resistance value, it is possible to maintain the amount of heat generation at 80°C or lower.

As a result, by controlling the operation of, particularly, the electric household appliance which requires large power flow, it is possible to effectively reduce power consumption of the whole electric household appliance within the building for a certain period of time.

By using the embedded type smart tap of the present invention, it is possible to cut peak power usage of an arbitrary electric household appliance, reduce the amount of power to be supplied to an arbitrary electric household appliance and shift operating time of an arbitrary electric household appliance, while detecting power consumption of the whole house without forcibly connecting the table tap to all the electric household appliance including the electric household appliance embedded in the wall or the ceiling, such as lighting.

The smart tap can (1) cut off power and (2) adjust power of each electric household appliance so that the power value is equal to or lower than an upper limit power value requested from the server and a peak cut power value by using the semiconductor device. Further, by providing an infrared remote control function, the smart tap can switch ON and OFF or reduce power.

It should be noted that as power amount adjusting means mounted at the outlet, a semiconductor relay (SSR: Solid State Relay), a mechanical relay, or a semiconductor device (triac and MOSFET: Metal Oxide Semiconductor Field Effect Transistor) can be utilized. However, in order to perform control so that the power amount does not exceed the peak cut power value, while it is possible to control ON and OFF by providing a mechanical or semiconductor relay, such a mechanical relay has characteristics that response speed is low.

Because the response speed is low, if the power amount requested by the electric household appliance sharply increases before response is completed, there is a possibility that the power amount cannot be controlled appropriately and may exceed the peak cut power value. Therefore, to prevent occurrence of such a case, it is necessary to provide a large margin of power amount for ensuring that the power amount does not exceed the peak cut power value even if the response is late, for example, it is necessary to perform control so that 70 to 80 W is set as an upper limit for an upper limit of 100 W. However, the mechanical relay can be effectively used for the electric household appliance which allows late response time.

Therefore, preferably, by using a semiconductor device with high response speed to be provided at the smart tap, it is possible to set a small margin so that the power value does not exceed the upper limit power value, and it is possible to easily ensure that the power amount does not exceed the upper limit value. Because the EoD system has a characteristics of controlling instant peak power with respect to a life usage plan of power in real time to ensure that peak power usage of the integrated power is cut, the semiconductor device, the semiconductor relay and the mechanical relay are preferable in this order to switch between ON and OFF and control power. Further, the semiconductor device is more preferable in terms of reduction in size.

Therefore, preferably, the smart tap used in the electric household appliance remote monitoring system of the present invention particularly employs the following structure.

Between each electric household appliance and electric equipment and a power supply (power grid, renewable energy or a rechargeable battery), a request packet indicating which electric household appliance requires how much power amount is transmitted in real time to the server, and, after the server judges (mediates) a power amount which can be supplied from the power supply, the server transmits a packet indicating power which can be supplied, to the electric household appliance side, that is, packet transmission is performed with each other after balance of demand and supply is judged (mediated), and, thereby power supply to the electric household appliance and the electric equipment is started. This is a power control system using the electric household appliance remote monitoring system.

In the electric household appliance remote monitoring system of the present invention, the smart tap can achieve functions (1) to (8): (1) a communication function such as transmission and reception; (2) a function of calculating power consumption; (3) a function of recognizing each electric household appliance and each piece of electric equipment by judging that current and voltage waveforms of each electric household appliance and each piece of electric equipment are those registered in the server; (4) a function of giving notification of detection of abnormality (abnormality such as electricity leakage) of each electric household appliance by comparing an actually measured waveform shape with a normal power waveform pattern, the function being expansion of the function of recognizing the current and voltage waveforms of the electric household appliance and the electric equipment; (5) a function of power control, switching ON and OFF, and remote control; (6) a sleep function and a wake-up function for reducing power consumption of the smart tap itself when the connected electric household appliance is not used; (7) a safety function for an abnormal current and an abnormal voltage from the electric household appliance and each power supply; and (8) a function of sensing environment (such as temperature and humidity).

Further, a behavior pattern of each user is learned, the priority of each electric household appliance and electric equipment are automatically recognized, and a power usage model is built. It is also possible to create a power usage plan using this power usage model, and set the power peak-cut value and the power upper limit value, and measure and calculate the instant upper limit value in real time, to thereby enable power control so that the power amount does not exceed the integrated peak power usage and the set upper limit value. Further, because a request from each electric household appliance is received in real time, and power saving and cutting of peak power usage are performed mainly on the electric household appliance with low priority while minimizing power saving for the electric household appliance and the electric equipment with high priorities in power saving and cutting of peak power usage by automatically or manually setting priorities, it is possible to realize power saving and cutting of peak power usage, particularly, integrated peak power usage without degrading comfort of the user (without making the user tolerant of power saving).

Further, computing means for recognizing the state of the electric household appliance and detecting abnormality (such as failure and electricity leakage) is provided inside the server. In this case, the computing means may be means for detecting that the voltage waveform and/or the current waveform, or the like, or the characteristic amounts of the voltage and/or current waveforms computed at the arithmetic device indicate some abnormality by comparing the waveforms and the characteristic amounts with the normal state ofthe electric household appliance, and, as a result, the computing means may be configured to be able to display whether or not there is abnormality using sound or light as necessary when abnormality can be found in the state of the electric household appliance.

Alternatively, while during normal operation, power consumption and the operation state of each electric household appliance being controlled by using the smart tap can be displayed at a display (TV, PC, monitor, mobile equipment (smart phone, TABLET-PC)), or the like, which is utilized to visualize power, when abnormality occurs, it is possible to display occurrence of abnormality at this display to notify the user of the abnormality.

With such means for recognizing the state of the electric household appliance and detecting abnormality, the electric household appliance is connected to the smart tap, the pattern such as the power waveform and the characteristic amount when the electric household appliance normally operates are stored in the server, and then, the power waveform appearing when the electric household appliance does not normally operate is compared with the stored power waveform.

By performing detection as described above, it is possible to detect failure, trouble or electricity leakage of the electric household device, abnormality of wiring (such as electricity leakage) and abnormality of the smart tap itself.

According to these constituent members, it is possible to realize the smart tap having the following structure.

A wireless device for measuring power and transmitting current and voltage waveforms is constituted on a rear side of a non-metal resin member on the front face of the smart tap at the side to which a plug is to be inserted. In this case, because the surrounding of the receiving part of the communication device is formed with a non-metal material, communication performance is not degraded. Meanwhile, the heating part of the electric control device which is provided further behind the communication device, dissipates heat to the metal chassis or the metal heat sink through an insulating heat dissipation member (sheet, adhesive sheet), thereby it is possible to maintain the temperature inside the smart tap and the chassis at 80°C or lower. That is, it is possible to suppress heat generation without degrading communication performance of the tap and use an inexpensive device without using an electric control device with small on resistance without shortening life of each device of the tap.

As a structure of the smart tap, when the wireless device is constituted on the rear side of the non-metal resin which does not degrade communication performance of the wireless device and the electric control device is provided behind the wireless device, it is also possible to utilize a chassis formed with a high thermal conductivity resin composite material, which has high thermal conductivity and insulation property, and provide the heat generating part and this insulating high thermal conductivity resin chassis across an insulating heat dissipation member.

By this means, it is possible to reduce heat generation without degrading communication performance and enable usage of an inexpensive control device.

It is possible to provide the communication device inside the smart tap, particularly, at a portion where communication is less likely to be inhibited, such as a metal, and, for example, in a structure where the communication device is constituted at the lateral side, a resin chassis which is less likely to cause communication inhibition is used. Therefore, as the power control device, by selecting a device which generates a small amount of heat and which has a small on resistance value, it is possible to maintain the amount of heat generation at 80°C or lower.

Further, detecting and communication means includes any one or more of publicly known sensors for detecting a state within a building, such as a motion sensor, a temperature sensor, a humidity sensor, a mass airflow sensor, an illuminance sensor and a locking sensor, and means for directly transmitting a result detected by the sensor directly to the server or wirelessly transmitting the result to the nearby smart tap.

When such detecting and communication means is used, data transmitted from the sensor to the server by the detecting and communication means is added to information transmitted from the smart tap to the server, processing is performed at the server based on the information, and the processing result is transmitted to the smart tap of the present invention.

Further, it is also possible to add an electric household appliance remote control function to the smart tap of the present invention. The remote control function in the case where the electric household appliance itself has a function of controlling power, is directed to an air conditioner, TV, a fan, an electric carpet, interior ceiling light, or the like, and switches ON and OFF of these electric household appliance or adjusts other operation. As such an electric household appliance remote control function, an infrared light and an HA terminal or ECOHNET Lite or a communication interface for ECOHNET, or the like, can be employed.

It is possible to add such a remote control function to the smart tap to make the smart tap serve as one of the control means of the power plug. In such a case, it is possible to utilize a remote control operation function of the electric household appliance in addition to control of operation of the connected electric household appliance by the power plug. Because the operation of the remote control is not directly performed by human, but is one of the control performed by the smart tap of the present invention, it is possible to realize finer operation for achieving target power consumption and peak power amount reduction based on the control signal from the server.

Meanwhile, it is not necessary to provide a remote control function to the electric household appliance which does not have a function of controlling power, such as lighting such as a light bulb, a pot, a refrigerator, an IH heater, a hot water bidet and a coffee maker, and these can be controlled by the power control device of the smart tap of the present invention.

Further, because the smart tap, if it is always turned on, consumes more power than standby power of the electric household appliance, a timer or various sensors such as a motion sensor, or an ON-OFF function of the smart tap by switching on and off particular electric equipment (for example, interior lighting of a store, or the like) and a sleep and wake-up function by powering on and off the connected electric household appliance may be provided. Particularly, as a function of the smart tap, it is designed that a threshold of power for waking up the electric household appliance from a sleep mode is set, and, for example, by setting a threshold between 1 and 10 W, it is possible to wake up the electric household appliance from a standby state at power equal to or greater than the threshold.

In order to confirm an operation state of such an ON-OFF function and the sleep or wake-up function, for example, an LED device, or the like, may be provided at an outer face of the front side of the smart tap or at an inner face where transmitted light can be displayed (it is possible to confirm by lighting of an LED, or the like).

An example of how to constitute the electric household remote monitoring system of the present invention will be described below.

According to the smart tap of the present invention, it can be considered that the following phases are sequentially gone through, phase 1 (visualization of energy consumption and learning and observation of human behavior), phase 2 (advanced power management using an EoD power network), phase 3 (power coloring using a nano grid within a house), and phase 4 (flexibility of energy using a local nano grid).

In phase 1, it is tried to make the consumer more conscious of power saving by visualizing an energy consumption pattern within the house, and waste of power consumption and action of the user are supported by learning and observing a state of each electric household appliance and the behavior pattern of the user using each electric household appliance.

Specifically, the smart tap of the present invention can be used in a usage state indicated in phases 1 to 4 described below.

It is judged whether the electric household appliance operates normally or operates abnormally by comparing the data with the past data of the electric household appliance at the server using any one or more of the voltage waveform, the current waveform, the characteristic amount of the voltage waveform, the characteristic amount of the current waveform of the present invention, and, optionally, the waveform of the power amount, and the characteristic amount of the waveform of the power amount.

It should be noted that it is also possible to employ one or more values among an effective voltage, an effective current, effective power, an integrated power amount, or the like, as one of the characteristic amounts.

Such judgment may be performed at any stage in phases 1 to 4 described below, and at any time point selected or set among a time point at which the electric household appliance is powered on, and an arbitrary time point.

### (Phase 1)

It is possible to employ publicly known means for measuring a voltage waveform of an AC current as the voltage waveform measuring means and the current waveform measuring means in the electric household appliance remote monitoring system of the present invention, and, the measurement is performed at a high sampling rate of approximately, 16 bits, and 10 to 30 kHz.

The voltage and current waveforms obtained by these voltage waveform measuring means and the current waveform measuring means are processed at the arithmetic device, and the processing result is transmitted to the server using the communication means. At this time, a microcomputer, or the like, incorporating DSP is preferably employed as the arithmetic device.

Because, recently, most of the electric household appliance includes an advanced control device such as a switching power supply and an inverter inside, a characteristic waveform unique to each electric household appliance appears in the current waveform within one AC cycle. Therefore, even if the electric household appliance consumes the same amount of power, it is possible to specify the electric household appliance and confirm the operation state of the electric household appliance by comparing patterns of the current waveform.

This function completely differs from the function of the conventional smart tap which merely visualizes power, and using this function, in the arithmetic device, the characteristic amount used for specifying the connected electric household appliance is specified by the characteristic amounts ofthe voltage and current waveforms. The characteristic amounts include, for example, peak values, cycles, and vectors at a reference time point, of the current and voltage waveforms, and the electric household appliance can be also specified with high accuracy using these characteristic amounts.

As described above, it is possible to derive the characteristic amounts using the arithmetic device and transmit the characteristic amounts to the server using the communication means. If the characteristic amounts are not derived, because the communication speed is required to be 16 bitsx20,000 Hz×2=640,000Hz in view of the data amount, it is impossible to perform transmission at the communication speed (250 kbps at a maximum) ofZigBee. Even if it is tried to increase the communication speed, it is impossible to employ communication means using a wide band if pursuing reduction in size and reduction in power consumption.

In ZigBee, a header such as an address, a transmission source and a data length, and a checksum are added to variable length payload of up to 78 bytes in one packet, and packets are transmitted. At this time, transmission and reception are performed while a setting command and property are set at the payload portion. For example, the smart tap of the present invention receives a command of 16 bits, and a setting value includes 0 to 592 bits, a format of data to be transmitted includes 16 bits, an acquisition time includes 32 bits, and a data portion includes 16 to 576 bits.

While raw data of the voltage and current waveforms with a large amount of data cannot be transmitted as is because of limitation of the communication speed as described above, by setting a table for characteristic extraction, it is possible to calculate and obtain the characteristic amounts of the voltage and current waveforms at the arithmetic device within the smart tap. At this time, the characteristic amount required for specifying each electric household appliance and confirming the operation state of the electric household appliance is not so large.

Description regarding communication will be provided below in three steps: (1) characteristic learning step; (2) electric household appliance learning step; and (3) electric household appliance recognition step, ofthe electric household appliance.

### (1) Characteristic learning step

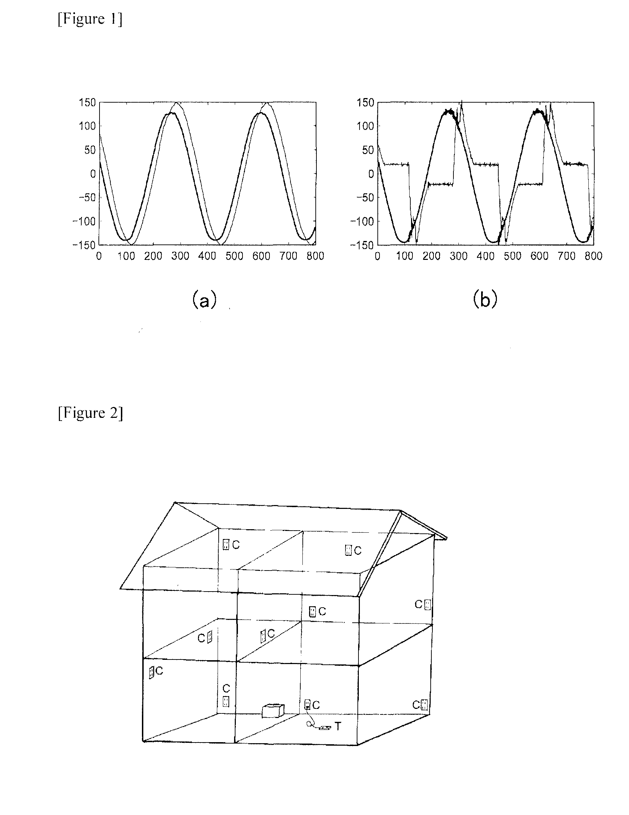

The characteristic amount is obtained with inner product ofthe current waveform measurement result obtained through the current waveform measurement and an eigenvector using the eigenvector obtained by analyzing principal components of the current waveform collected from a plurality of electric household appliance in advance. The voltage waveform and the current waveform of each electric household appliance are different from each other depending on the electric household appliance as illustrated in Figure 1 ((a) indicates a waveform of a hair dryer and (b) indicates a waveform of a vacuum cleaner, and a thick line indicates a voltage waveform curve and a thin line indicates a current waveform curve). It is therefore necessary to analyze characteristics of these waveforms to specify the electric household appliance.

Because the conditions for obtaining the characteristic amounts do not depend on each electric household appliance, data for comparison for obtaining the characteristic amounts is learned in advance and stored in the arithmetic device, or the like, of the smart tap of the present invention.

Further, as a message for transmitting the voltage and current waveforms from the smart tap to the server in advance, for example, the waveform information is set as WH=16 bits, the acquisition time is set as 32 bits, and the cycle is set as 16 bits, and the waveform data is indicated using a format including 16 bits of WD, 16 bits of index, 16 bits of the number of data, 16 bits of voltage (i), 16 bits of current (i), 16 bits of voltage (i+k), and 16 bits of current (i+k). Meanwhile, as a format of a message for setting the characteristic extraction table at the smart tap, the table information includes 15 bits ofFH, 8 bits of characteristic number, and 16 bits of a cycle, and the table data includes 16 bits of FD, 16 bits of index, 16 bits of the number of data, 16 bits of table (i) and 16 bits of table (i+k).

Because the data having the above-described data amount cannot be held in one packet, the data is divided into a plurality of packets and transmitted while the data corresponding to one cycle is held in an internal memory of the smart tap. The waveform information is transmitted using a packet to which an identifier WH is added, and, then, a data portion is transmitted to the server using a plurality of packets along with the identifier WD, start index and the number of data.

In a similar manner, when the characteristic extraction table is set, the table information indicated in the identifier FH and the data portion indicated in the identifier FD are divided into a plurality of packets and transmitted to the server.

### (2) Electric household appliance learning step

In a step of learning each electric household appliance, because learning is performed using the characteristic amount extracted at the smart tap, it is only necessary to transmit only a small amount of the characteristic amount.

As an example of the format for the characteristic amount extraction message, DF is 16 bits, acquisition time is 32 bits, an effective voltage is 32 bits, an effective current is 32 bits, effective power is 32 bits, an accumulated power amount is 32 bits, the characteristic amount is 32 bitsx4 and the cycle is 16 bits. DF is used as an identifier for indicating a type of the data, and a total of 320 bits of the acquisition time, the effective voltage, the effective power and the accumulated power amount, four characteristic amounts, and the cycle are put into one packet ofZibBee as one message and collectively transmitted to the server. Further, the current waveform and the voltage waveform may be transmitted to the server as the characteristic amount.

### (3) Electric household appliance recognizing step

In the electric household appliance recognizing step, in a similar manner to the electric household appliance learning step, recognition is performed using a small characteristic amount extracted inside the smart tap. At this time, learning is performed using the same characteristic extraction message as that in the electric household appliance learning step.

At this time, if possible, whether or not the connected electric household appliance normally operates can be detected based on the characteristic amount of the current waveform.

### (Phase 2)

After the electric household appliance is recognized using the characteristics of the electric household appliance in phase 1, the phase proceeds to phase 2.

In phase 2, power supply to the electric household appliance is controlled according to a power supply state and the priorities of usage of the electric household appliance which is being used while the server performs mediation for power supply. The power management technique called EoD is used to reduce consumed energy more actively.

The EoD is a mechanism for, when the load apparatus of the electric household appliance is powered on, fundamentally converting a mechanism of the power network so far until required power is always supplied, determining the priorities of the equipment, mediating the power usage amount and a time period during which power can be supplied to the equipment and assigning the power usage amount and the time period in a best effort manner.

In phase 2, a demand mediation protocol for a single power supply is defined, the single power supply being selected from a plurality of power supplies including grid power, photovoltaic generation (PV), wind power generation, small hydroelectric generation, a fuel cell and a rechargeable battery in a house, a building and facility. A procedure of the demand mediation protocol of EoD will be described below.
A. A power request message at the electric household equipment side is transmitted from the smart tap to the server at regular time intervals using bidirectional packet communication. The power request message includes a power amount required when the electric household appliance connected to the smart tap operates and/or a power amount successively required during operation.
B. The server determines the priorities of the electric household appliance which transmits the power request message and the electric household appliance which is operating (load apparatuses) based on the amount which can be currently supplied, and/or a life pattern in the house acquired in phase 1, the power consumption of each electric household appliance, a difference between the planned power amount and the consumed power amount, or the like.
C. According to the priorities of the load apparatuses, a power assignment message including the allowed power amount and the allowed time period is transmitted to each electric household appliance or a refusal message is transmitted to equipment to which power cannot be supplied, through bidirectional packet communication. The electric household appliance which is allowed to use power starts or continues operation, or performs operation while reducing or increasing power consumption.
D. The electric household appliance which is allowed to use power operates at the allowed power only for the allowed time period. The electric household appliance which is not allowed to use power requests reassignment (EoD) after a certain period has elapsed.

This series of process is not intended to supply power for initially activating the electric household appliance when the electric household appliance is powered on through the operation of the user or by a sensor or a program such as a timer. Initially, a packet indicating a requested power amount for each electric household appliance is transmitted from the smart tap to the server, supply performance of a single power supply or a plurality of power supplies is judged at the server receiving the packet, and if power can be supplied, the server returns a control signal that power is supplied to the smart tap.

The smart tap receiving this control signal starts or stops power supply to the connected electric household appliance according to the control signal.

Processing in the server and judgment as to whether power is supplied to the electric household appliance in this series of process will be described in more detail. Power supply to the electric household appliance is judged at the server taking into account the power amount which can be supplied from a single power supply or a plurality of power supplies.

Particularly, if power which can be supplied is tight with respect to a sum of power to be used at the electric household appliance which is likely to be used, when the peak power usage is cut, for example, an upper limit of the power is restricted, the information such as the priorities of the electric household appliance which is operating is sequentially updated, and, when the electric equipment is newly powered on, the priorities of the electric household appliance is updated to include this new electric equipment, and it is judged whether or not power is supplied to the electric household appliance which is newly powered on based on the power amount which can be supplied and the priorities of the electric household equipment.

Further, the priorities can be further taken into account to judge whether power is supplied to the electric household appliance at the server by also considering the behavior pattern of the user. That is, the power usage model is created within the server and the power usage plan is created by learning the behavior pattern of the user. Then, by always obtaining instant peak power in real time and comparing this peak power with the power usage plan, it is also possible to control the integrated value of the peak power of each electric household appliance so as not to exceed the power to be supplied and the power of the power usage plan.

At the same time, if possible, it is possible to detect whether or not the connected electric household appliance normally operates by comparing the characteristic amount of the current waveform at the server.

In this method, the user can reduce power consumption as desired by the user himself by setting the maximum power amount which can be supplied.

As described above, the EoD system makes it possible to determine the priorities ofthe electric household appliance taking into account characteristics and power of the power supply of each electric household appliance, and stop or reduce power supply to the electric household appliance with low priority.

Equipment incorporated in the EoD system includes three types: the electric household appliance which is equipment at a demander side, power supply facility which is equipment at a supplier side, and a rechargeable battery which temporarily accumulates power.

Three types of control performed for performing mediation for a single power supply at the demander side in phase 2 will be described using the following examples of the electric household appliance.
A. Adjustment. Lighting, a drier, or the like, are not practically influenced even if the supplied power amount is reduced with respect to the requested power, although performance is degraded in some degree. It is possible to reduce supply power instead of supplying power requested from the equipment side for these equipment.
B. Standby. Concerning the electric household appliance such as washing machine and a rice cooker, which automatically operates for a certain period of time after being activated, if the operation can be completed within a target finish time, a timing for activation may be delayed. It is possible to shift the timing for actually activating these electric household appliance from the requested time for the appliance.
C. Suspension. Because the electric household appliance such as an air conditioner and a refrigerator, which controls heat, can maintain the temperature even if the operation stops for a short period of time, it is possible to suspend the operation.

Because the electric household appliance is included or not included in these categories A to C, the electric household appliance can be divided into eight patterns taking into account whether the electric household appliance can be included or not included in these three categories. The electric household appliance which is not included in any of these three categories is the appliance which should operate in any case, and is the appliance having the highest priority for power supply.

The results classified as described above will be indicated in Table 1.

**[Table 1]**

| Class | Adjustment | Standby | Suspension | Electric household appliance |
|---|---|---|---|---|
| 1 | YES | YES | YES | Notebook computer, water heater |
| 2 | YES | YES | NO | Hot water bidet, microwave |
| 3 | YES | NO | YES | Heater, air conditioner, refrigerator |
| 4 | YES | NO | NO | TV, drier |
| 5 | NO | YES | YES | Dishwasher, washing machine |
| 6 | NO | YES | NO | Rice cooker, toaster |
| 7 | NO | NO | YES | Copy machine, electric jug |
| 8 | NO | NO | NO | Gas security detector, artificial respirator, network equipment such as router |

Table 2 indicates property of classes of the electric household appliance. In the demand mediation protocol of EoD, the electric household appliance which requests power first transmits to the server the power assignment message to which property is added.

The server compares the power which can be supplied with the requested power and transmits the power assignment message to the smart tap if power can be supplied. If power cannot be supplied, the server reduces the amount of power supplied to the electric household appliance which is currently used and which has low priority or transmits a message for refusing power supply to the electric household appliance which requests power.

**[Table 2]**

| Property | Value | Remarks |
|---|---|---|
| Electric household appliance ID | ID | Identifier of electric household appliance |
| Electric household appliance class | 1-8 | |
| Requested power | Numerical value (W) | Common |
| Minimum starting power | Numerical value (W) | Electric household appliance classes 1 to 4 |
| Period during which electric household appliance can be suspended | Numerical value (second) | Electric household appliance classes 3, 4, 7 and 8 |
| Starting expected time | Time | Electric household appliance classes 2, 4, 6 and 7 |
| Operation expected time | Numerical value (second) | |
| Priority | 0-1 | 1 indicates the highest priority |
| Supply method | DC, AC, voltage | |

The smart tap is notified of whether or not power can be assigned from the server in this manner. The notification includes whether assignment is allowed or refused as a response to the power request, and includes whether the operation is suspended or assigned power is changed as a message to the electric household appliance which is operating.

If the assignment is allowed or in the case of the reassignment, a maximum value of power to be assigned to the electric household appliance (assigned power) and an assigned time period are added as property. Meanwhile, if the assignment is refused or the electric household appliance which is operating is stopped, time for the electric household appliance to request power again is added. The supply power is an ID of a power supply which supplies power and is required for dispersed power supplies in phase 3.

### (Phase 3)

After power supply is controlled in phase 2, in phase 3, power is supplied from a plurality of power supplies including photovoltaic generation (PV), wind generation, small hydroelectric generation, a fuel cell and a rechargeable battery, or the like, in addition to a grid power supply (including a plurality of grid power) which is the most typical power supply. In addition, control is performed in a similar manner in phase 2 for control of the connected electric household appliance through control of the smart tap from the server.

The dispersed power supplies are efficiently managed using a nano grid in the house having a power coloring function (function for distinguishing a power supply among power to be supplied) for controlling a source of power supply for each power supply.

If a plurality of dispersed power supplies are provided within the house, efficient power supply is realized by making it possible for the EoD protocol in phase 2 to select power from the plurality of power supplies and associating the power supplies with the electric household appliance while maintaining demand balance. To achieve this, it is necessary to take appropriate action based on the characteristics of demand and the characteristics of the power supplies. At this time, it is necessary to also determine the priorities for power supply of the power supplies. To determine the priorities, the power supplies are classified into four types as indicated in Table 3 according to stability as to whether the power which can be supplied is constant or can be controlled, or readiness as to whether or not a delay occurs when the supply power is changed.

For example, grid power from the power company has stability and readiness, while the power which can be supplied by a photovoltaic cell depends on weather, and, thus, the photovoltaic cell lacks stability while having readiness.

**[Table 3]**

| Class | Stability | Readiness | Example of power supply | Electric household appliance to which power can be supplied |
|---|---|---|---|---|
| A | ○ | ○ | Grid power | 1-8 |
| B | ○ | × | Fuel cell | 1, 3, 5, 7 |
| C | × | ○ | Photovoltaic cell | 1, 2, 5, 6 |
| D | × | × | | 1 |

Each power supply has various parameters as indicated in Table 4 below. Because the fuel cell and cogeneration generates power and boils water at the same time, the power amount which can be supplied fluctuates according to the amount of hot water. Further, the user can set the power consumption or the upper limit of the power amount under ceiling of the maximum supply power and the accumulated power amount.

The rechargeable battery can be positioned as the electric household appliance during charging and as a power supply during discharging.

**[Table 4]**

| Property | Value | Remarks |
|---|---|---|
| Power supply ID | ID | Identifier of power supply |
| Power supply class | A-D | |
| Supply power | Numerical value (W) | Power currently being supplied |
| Maximum power | Numerical value (W) | Power which can be currently supplied |
| Power amount which can be supplied | Numerical value (Wh) | Accumulated power amount which can be currently supplied |
| Ceiling | Numerical value (Wh) | User set upper limit |
| Delay time | Numerical value (yen/W) | Delay time due to change of output |
| Power cost | Numerical value (yen/Wh) | Electricity expense per unit power amount |
| CO₂ emission amount | Numerical value (ml/Wh) | Emission amount per unit power amount |
| Power transmission method | DC, AC, voltage, or the like | |

In EoD, the supply source and the supply destination can be determined using the power supply selection protocol according to the following procedure.
A. Each power supply transmits power supply property to the server.
B. A power plug device transmits a power assignment message indicating power to be assigned to the electric household appliance to which the electric household appliance property is added, to the server.
C. The server determines the priorities of the power supplies to the electric household appliance in an ascending order of power cost or a CO₂ emission amount from the power supplies which can supply power, listed in Table 3 according to classes of the electric household appliance.
D. Whether power can be supplied is judged in a similar manner to the demand mediation protocol in a descending order of the priorities of the power supplies, and the power assignment message is transmitted to the power plug device.
E. The power plug device, when receiving the power assignment message, supplies power to the associated electric household appliance according to the message.

The rechargeable battery switches a mode between a charging mode and a supply mode according to a storage amount, states of other power supplies and a power supply state, and requests power as a load apparatus in the charging mode, while being included in the power supplies during power mediation in the supply mode.

### (Phase 4)

In phase 4, a nano grid implemented within the house is also implemented for each neighboring area. At this time, it is necessary to constitute the power plug apparatus to support exchange of information within the area.

The smart tap of the present invention is used in the above-described EoD system and will be described in detail below.

Figure 2 of the present invention illustrates layout of embedded outlets for the on-demand power control system, where C indicates an embedded outlet. In the figure, a plurality of smart taps of the present invention are provided as the embedded outlets in the building. It is also possible to optionally use a tap indicated by T in the figure. In principle, one server is provided at one house, and a communication network is built so as to be able to perform communication among all the embedded outlets within the house.

When T is connected to C, because the smart tap of the present invention is connected in series in one system, processing is performed to stop a function of any one of T and C, preferably, an outlet C side.

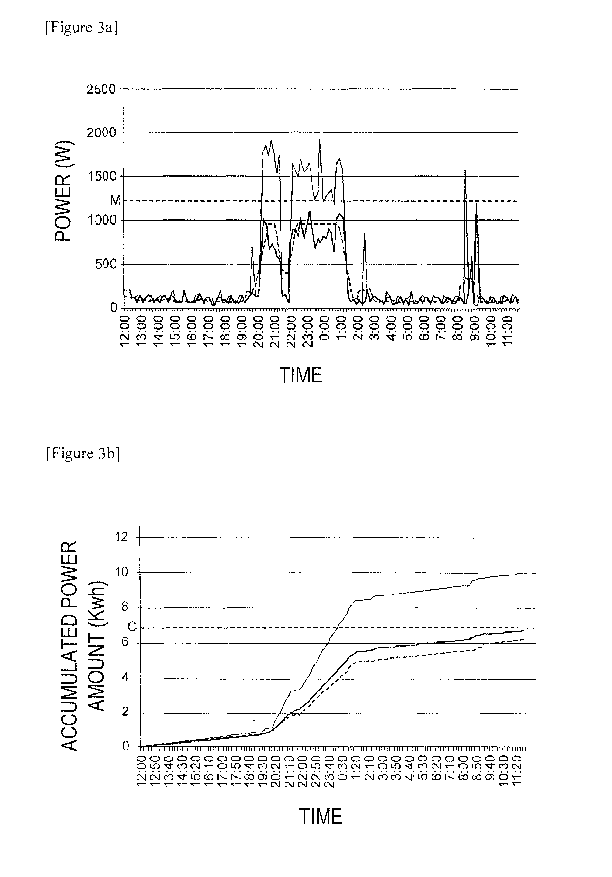

Figure 3 is a schematic diagram illustrating transition of power of the whole house when various electric household appliance is used at an input voltage of 100V in one house.

In Figure 3, a solid line indicates power in the case where EoD is not performed, a dashed line indicates a target value obtained by performing EoD, and a dashed-dotted line indicates a control simulation result in the case where EoD control is performed based on an actual measured value of each electric household appliance.

Figure 3(a) illustrates data of a current value of an instant peak from noon of a given day to noon of the next day, and a power value in actual life with respect to a power plan of power reduction target indicated by a line which has a smooth peak.

A line fluctuating vertically and irregularly in a region below the dashed line indicates the control simulation result. Further, a line over the dashed line indicates data in actual life.

According to the control indicated in Figure 3(a), the power actually used does not exceed 1200W indicated by a dotted line M, and the instant peak does not exceed 1200W.

Figure 3(b) is a diagram where instantaneous power consumption indicated in Figure 3(a) is integrated, and data in the case where a limit value of the instantaneous power value in one day is set 30% or lower. Data in actual life exceeds the target of the integrated power consumption value indicated by the dotted line.

However, by performing control using the smart tap of the present invention while setting the limit value at 30% or lower, it is possible to obtain a simulation result where data increases slightly below the line positioned on the dotted line C at noon in the next day when control is performed.

From these results, according to the present invention, for example, when cutting of the upper limit peak power consumption is set at 30%, data does not exceed the upper limit, that is, it is possible to quantitatively secure power reduction.

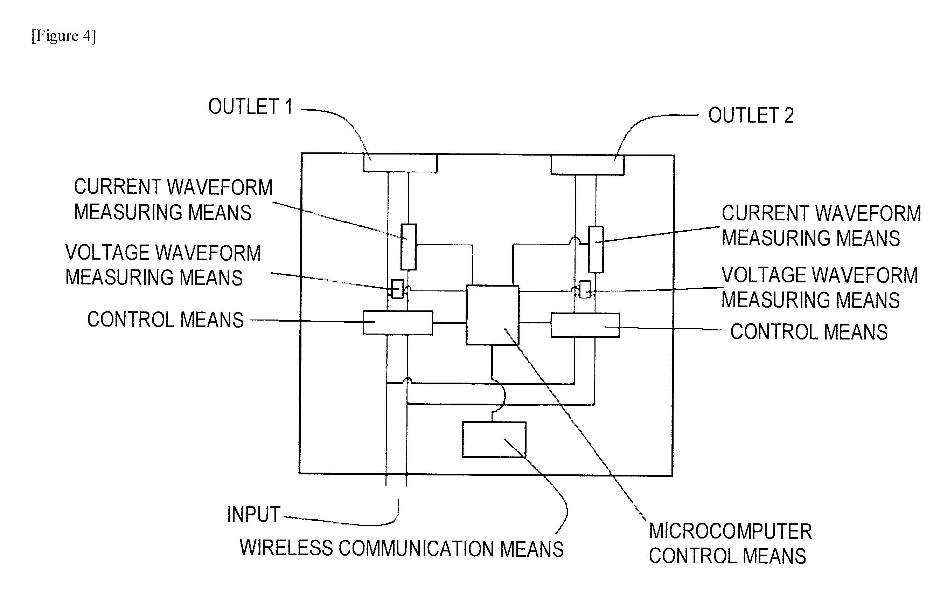

Figure 4 illustrates an internal configuration diagram of one example ofthe embedded outlet as a tap used in the electric household appliance remote monitoring system of the present invention.

The smart tap of the present invention is powered on from wiring within the building as with a typical embedded outlet or tap, is branched into two in the case of an outlet having two slots or branched into three in the case of an outlet having three slots inside, and also functions as an outlet for output having two or three slots, and includes necessary parts for realizing this structure.

Further, in addition to such a structure, the smart tap of the present invention includes voltage waveform measuring means, current waveform measuring means, computing means and an arithmetic device, and control means for measuring the power amount and computing the power amount for each output, and further includes communication means for transmitting signals from these means to the server which is not illustrated and receiving a control signal from the server.

It should be noted that also in the embedded outlet or tap having two or more slots, these plurality of outputs may be integrated and may be made to operate by one arithmetic device and one communication means.

The electric household appliance remote monitoring system of the present invention can be provided in office, a building, factory, tenant, a mass retailer, hospital, elderly facility, supermarket, or the like, in addition to a house, collective housing, an apartment building and a house also used as a store. While the smart tap of the present invention is provided at a normal location or an arbitrary location on the wall of the building in these buildings as illustrated in Figure 2, in principle, the server with which the communication means performs communication is preferably provided within the same building. While there is typically one server within one building, when a plurality of houses exist within one building such as a house also used as a store and an apartment building, or when one building is divided into a plurality of units, such as office, factory and tenant, the server can be provided for each house or unit. One server can perform communication with a plurality of smart taps, and it is possible to select a server which can process communication and obtained information taking into account the number of embedded outlets and taps provided in a typical house.

It should be noted that when the electric household appliance remote monitoring system is provided in office, a building, factory, tenant, a mass retailer, hospital, elderly facility, supermarket, or the like, in addition to a house, collective housing, an apartment building and a house also used as a store, a server may be provided outside each building, or cloud can be utilized.

It is also possible to utilize cloud, an external server, or the like, via a gateway (GW) such as a home gateway (HGW). By this means, for example, the EoD system within the house can be controlled at the GW, while overall power data in association with mass lives can be controlled using cloud, the external server, or the like. Further, when EoD control is performed on a plurality of houses or buildings such as smart community using this tap, it is possible to utilize the GW to specify data of each house and office.

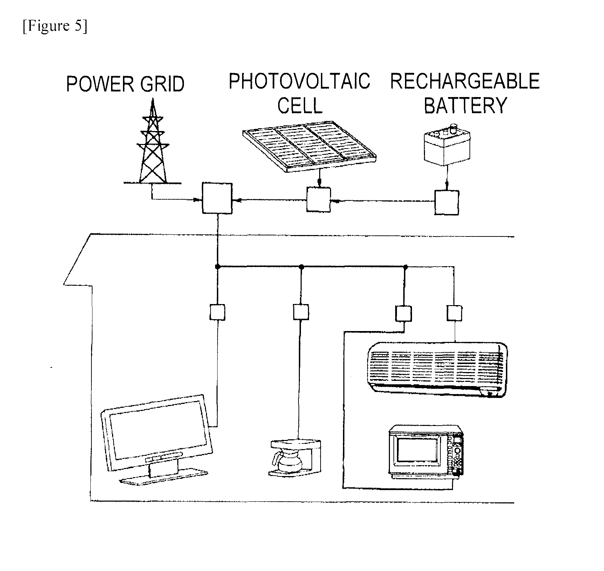

Further, as illustrated in Figure 5, by connecting a power supply which supplies power to one house, to photovoltaic generation and wind generation which are renewable energy sources, and an electric storage device, rechargeable battery devices of hybrid vehicles and electric vehicles, and other power supplies in addition to an existing power grid, it is possible to supply power to the house from two or more types of power supplies.

In this case, by connecting the smart tap of the present invention to each power supply with reference to the points listed in the above-described Table 3 and Table 4, it is possible to perform control to reduce energy loss, substantially save power while improving comfort and efficiently cut peak power usage by selecting an arbitrary power supply from a plurality of power supplies, determining the amount of power to be supplied from each power supply and selecting the electric household appliance to which power is supplied from the arbitrary power supply.

Further, by using a plurality of power supplies as described above, for example, even if a DC power supply instead of an AC power supply is connected to the electric household appliance in an eco house, or the like, the smart tap ofthe present invention can be also used. In such a case, power supplied to the house, or the like, on AC and power supplied to all the electric household appliance or part of the electric household appliance is converted into DC using an AC/DC converter, and the smart tap of the present invention is used as a tap for supplying DC to the electric household appliance.

It should be noted that, in the case of DC power feeding utilizing renewable energy such as photovoltaic generation and wind generation, and a power supply device such as a fuel cell and a rechargeable battery, power to be supplied to the electric household appliance or power to be supplied to part of the electric household appliance is converted using an AC/DC converter, and the smart tap of the present invention can be used as a tap for supplying the DC to the electric household appliance. The supply voltage of the DC at this time can be set at a low voltage of 24V, 12V, or the like, taking into account safety. In this case, examples of the electric household appliance to which DC is to be supplied include low power equipment such as lighting, PC and its related equipment, and the electric household appliance conventionally using an AC/DC converter for each electric household appliance, such as a phone. Particularly, for the electric household appliance conventionally using an AC/DC converter, by reducing loss at the AC/DC converter, it is possible to realize higher power usage.

Further, for the electric household appliance with high power consumption, such as IH cooking equipment and an air conditioner, it is also possible to employ an AC power supply taking into account danger because a DC of a high voltage of 200V is used. In this case, part of power branching from the AC is converted into a DC. If a DC of a high voltage can be safely used, it is also possible to convert all the AC supplied from outside into a DC and use the smart tap of the present invention for this DC.

As described above, a smart tap for a DC power supply among the smart tap of the present invention can be used while being embedded in the wall as in the case of the smart tap for an AC or can be used while being inserted into the outlet provided on the wall as in the case of the table tap, by employing voltage detecting means and current detecting means for a DC and control for a DC. Also at this time, current and voltage waveforms unique to the electric household appliance are detected, and the electric household appliance connected to the smart tap is recognized.

Particularly, as described above, when power is supplied to a house from two or more types of power supplies and a smart tap for a DC is used by connecting a DC power supply such as a renewable energy source such as photovoltaic generation and wind generation, an electric storage device, a rechargeable battery device for a hybrid vehicle and an electric vehicle, in addition to an existing power grid as a power supply which supplies power to one house, because there is no need for converting the DC supplied from the photovoltaic generation, the electric storage device and the rechargeable battery device into an AC, no conversion loss occurs. Further, also for these DC power supplies, it is possible to provide a smart tap at a panelboard of a DC power supply, or provide a smart tap in place of a panelboard and collectively control a DC current system. Further, by providing a smart tap at each power supply so that the power supply side becomes upstream, it is possible to individually control power supply from each power supply.

In this case, by connecting the smart tap of the present invention at each power supply, an arbitrary power supply is selected from a plurality of power supplies, the amount of power supply from each power supply is determined, and the electric household appliance to which power is supplied from an arbitrary power supply is selected, so that it is possible to reduce an energy loss and perform control to efficiently cut peak power usage.

Eventually, regardless of an AC or a DC, the smart tap of the present invention can be provided as an embedded outlet in the wall portion, the ceiling portion, the floor portion, or the like, or can be provided as a tap connected to such an embedded outlet, the conventional embedded outlet or a tap, or can be provided at the panelboard, so that it is possible to control power to be supplied to the electric household appliance or a power line connected at the downstream side.

As a smart tap, it is possible to use a smart tap having an internal structure as illustrated in Figure 6, for example, as the first form. It should be noted that in the following figure, MOSFET is employed as the control means.

Figure 6 is a diagram schematically illustrating internal arrangement of a smart tap at an outlet having two slots. As the control means, four MOSFETs 1 are provided for each slot, and one current measuring means 2 is provided for each slot, and, further, although not illustrated, one voltage measuring means is provided for each slot. Further, one arithmetic device and one communication means are shared between two slots. As is clear from the figure, a circuit board for arithmetic device power supply is provided, and, in order to facilitate dissipation of heat generated at MOSFET 1 to outside of a power plug, MOSFET 1 is provided at four corners, and the arithmetic device 3 and the communication means 4 are provided away from the MOSFET 1. It should be noted that at least two MOSFETs 1 are provided and up to four to eight MOSFET 1 can be provided.

By employing such arrangement, it is necessary to prevent the arithmetic device 3 and the communication means 4 from being heated as possible as they can.

By employing control means which is a power control device having a small amount of heat generation, that is, having small on resistance, because the amount of heat generation becomes small, it is not necessary to use a metal material which does not have radio wave transmissivity. Further, because it is possible to form at least part of the chassis with a resin having low heat dissipation, it is possible to secure transmissivity of radio waves required for performing communication with the server.

In this case, by selecting a device having a small amount of heat generation, that is, having a small on resistance value as the power control device, it is possible to maintain the amount of heat generation at 80°C or lower.

As the second form, Figure 7 and Figure 8 illustrate examples, which are different from the structure of the smart tap illustrated in Figure 6, where two MOSFETs 1 which are control means are provided for each slot of the outlet at the substrate of the smart tap, immediately below the front face or further behind, the front face being formed with a resin through which radio waves can transmit. Figure 7 and Figure 8 are configuration diagrams of one example of the smart tap of the present invention, and Figure 8 illustrates a state where the components in Figure 7 are partly assembled and seen from a different direction.

In Figure 7 and Figure 8, the communication means 4 and its substrate are provided at the rear side, for example, in the center portion of the front face 6 of the smart tap formed with a material which is a non-metal resin material such as a resin and through which radio waves can transmit. Therefore, signals communicated by the communication means 4 pass through the front face 6 of the smart tap and, for example, can perform communication with the server. Further, although not illustrated, it is also possible to provide an LED for indicating an operation state of the smart tap and its substrate and a substrate for rewriting firmware of a wireless module and a microcomputer at the central portion of the substrate. Rewriting of the firmware of the wireless module and the microcomputer may be any of rewriting and updating using an USB terminal or wireless rewriting in the case of the embedded smart tap.

Further, when MOSFET 1 is provided near the central portion of a long side of the substrate 7 positioned inside the front face 6 of the smart tap, to address a case where MOSFET 1 is heated by operation of the smart tap, although not illustrated, an insulating heat dissipation sheet is provided so as to contact both MOSFET 1 and the chassis 8.

Therefore, heat generated at MOSFET 1 is transferred through the insulating heat dissipation sheet which serves as a heat dissipation member, and further transferred to the metal chassis 8 and a metal heat sink. Because the chassis 8 dissipates heat within the wall at which the smart tap is provided, it is possible to smoothly dissipate heat from MOSFET 1, so that it is possible to maintain the temperature inside the smart tap and the chassis at 80°C or lower.

It is therefore possible to use an inexpensive device instead of using a power control device having small on resistance.

Further inside of the substrate 7 where MOSFET 1 is provided, although not illustrated, a substrate 9 where voltage waveform measuring means, current waveform measuring means, and an arithmetic device such as a CPU are provided, is provided. Heat generated at MOSFET 1 is not directly transferred to these means and device, and heat is transferred to the chassis 8 through contact, so that these means and device are not excessively heated.

Further, it is also possible to provide a substrate 10 inside. At a back side of the substrate 10, a control device 11 such as MOSFET which can support high load can be provided in preparation for a case where the electric household appliance to be connected has high load.

If it is prioritized to form the smart tap itself as a low back type, the smart tap is constituted with a semiconductor device such as MOSFET having a power control and switching function at the substrate 7, and if there is latitude in depth when the smart tap is displaced, it is possible to provide MOSFET at the substrate 10. Therefore, the power control device which becomes heat generating part can employ any structure.

Further, as described above, MOSFET is preferably constituted at a portion distant from the microcomputer or the wireless module in the case of high current electric household appliance or the electric equipment. While the smart tap of the present invention can be implemented by providing each substrate as described above, the arrangement of each substrate and an element provided at each substrate can be modified as appropriate within the scope not degrading the advantage of the present invention.

### Usage of smart tap for each connected electric household appliance

While the smart tap of the present invention recognizes the connected electric household appliance as described above, and, when the electric household appliance is powered on, controls operation of the connected electric household appliance while controlling other electric household appliance through communication with the server, in order to appropriately use the smart tap for various electric household appliance, it is also possible to provide an infrared transmission function or a remote control function such as home automation (HA) at the smart tap.

To operate the electric household appliance using such a smart tap, a usage aspect of the smart tap can be classified into three categories according to types of the electric household appliance.

As the first category, when the electric household appliance has a so-called remote control function as part of TV, lighting or an air conditioner in a bed room or a living room, and the electric household appliance itself has a power consumption control function, the voltage waveform measuring means, the current waveform measuring means, the current measuring means, the voltage measuring means, the power consumption computing means, the communication means, the detecting means and the remote controller controlling means of the smart tap can be implemented when the smart tap is connected. That is, while the electric household appliance itself has a remote control function and a control function, by making these functions coordinate with a remote controller bridge function of the smart tap, it is possible to power on and off the electric household appliance using a power control and switching function, and by detecting which electric household appliance requires how much power consumption is detected and notifying the server of a request message, it is possible for the server to stop or suspend power supply to the electric household appliance or adjust power after the server receives a power supply message indicating a judgment result of the power state of other electric household appliance.

As the second category, when the electric household appliance which does not have a remote control function and for which power control is complicated, such as part of a microwave, washing machine, a humidifier, a fan heater and a rice cooker, is connected to the smart tap, which electric household appliance requires how much power consumption is measured and computed, and the server is notified of the result as a request message, and a supply message which is a result of judgment of the power state of other electric household appliance at the server is received. By this means, power is supplied to the electric household appliance or power supply is stopped. However, in this case, power control of the electric household appliance cannot be performed, and a function of switching on and off is achieved.

Because such electric household appliance is likely to be replaced by network electric household appliance having a remote control function in the future, at that time, it will become possible for the tap to perform control as performed on the remotely controlled electric household appliance.

As the third category, when the electric household appliance such as lighting at the entrance, kitchen, lavatory, bathroom, shower room, IH equipment, a refrigerator, a pot, and a hot water bidet is connected to the smart tap, these electric household appliance is controlled by utilizing all the means of the smart tap, including the arithmetic device.

It is possible to connect a chip fuse, a poly-switch, a glass tube fuse, or the like, to an internal circuit in the smart tap of the present invention as protection against overcurrent to prevent reverse current from the connected electric household appliance or prevent abnormal current from each power supply.

It is also possible to provide a switching surge protection function for suppressing high voltage generated by on and off of a varistor and a power control semiconductor device and an overheat protection function for suppressing heat generation at the power control device as protection against overvoltage, at the internal circuit.

Further, when the connected electric household appliance is powered off and requires only standby power, there is a case where it is necessary to reduce power consumption of a circuit itself within the smart tap for supplying power to the smart tap to which the electric household appliance is connected or the outlet of the smart tap.

In such a case, it may be necessary to reduce power consumption of the smart tap itself or a circuit itself within the smart tap to which the electric household appliance is connected. Therefore, if the power supplied to the connected electric household appliance is equal to or less than the standby power of the electric household appliance, the smart tap is put into a sleep state and maintains its state. In this sleep state, all the functions of the smart tap are not completely suspended, but, for example, only the communication means may be powered on, so that the communication means can perform communication with the server when the connected electric household appliance is powered on.

It is also possible to provide a wake-up function for starting operation when power to be supplied to the electric household appliance is equal to or greater than the standby power of the electric household appliance, and a function for displaying the wake-up state using light, or the like.

Further, it is also possible to power on the smart tap at an arbitrary time by providing a timer. The wake-up function may be achieved by detecting a DC waveform, or the like, from the current waveform measuring means provided within the smart tap.

Still further, it is possible to create a pseudo sine wave of an AC waveform from an analog signal which is a DC waveform from the current sensor and set a threshold of power to wake up and activate the smart tap using variable resistance. By this means, it is possible to finely adjust the threshold between 1 and 10 W, and, when the power is equal to or greater than the standby power of the electric household appliance to be used, by detecting the operation state of the electric household appliance, it is possible to start activation and reduce power consumption of the tap itself which is put into a sleep state, or the like, when the power is equal to or lower the threshold.

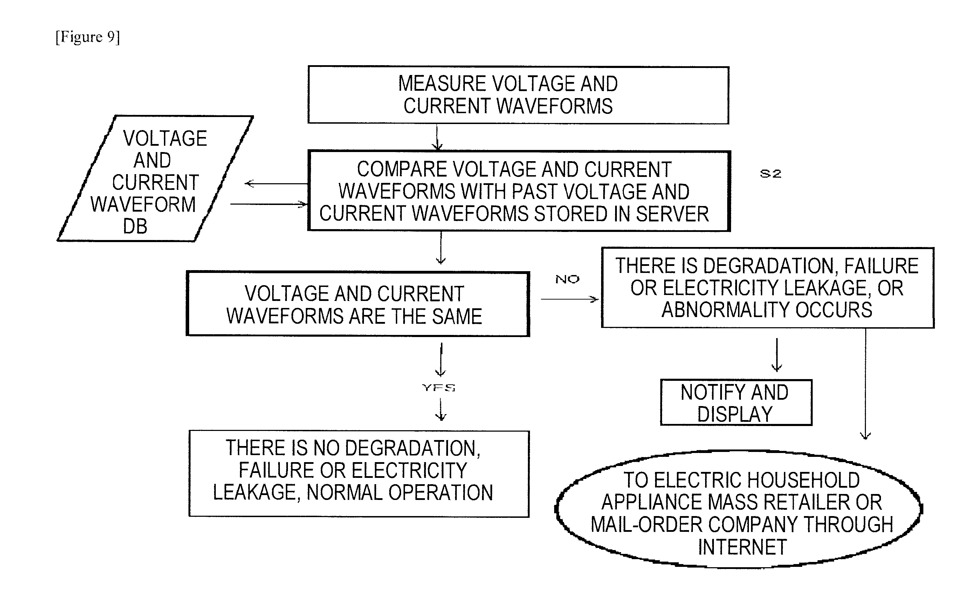

Figure 9 is a flowchart illustrating one example of the electric household appliance remote monitoring system of the present invention, and, when the electric household appliance is powered on, first, the voltage waveform and the current waveform are measured within the smart tap and transmitted to the server.

The measurement result is transmitted to the server, and the server extracts the past voltage waveform and the past current waveform ofthe electric household appliance stored in a voltage and current waveform DB, and in S2, compares the measured voltage waveform, current waveform with the extracted voltage waveform and current waveform and acquires points where the waveforms match and points where the waveforms do not match.

As a result, it is judged whether the measured voltage waveform and current waveform are the same as the extracted voltage waveform and current waveform. At this time, reference for judging occurrence of degradation, failure or electricity leakage of the electric household appliance through a difference in the voltage waveforms and the current waveforms is set in advance for each electric household appliance, and it is judged whether the measured voltage waveform and current waveform are the same as the extracted voltage waveform and current waveform according to the reference.

If the result is Yes, it is judged that there is no degradation, failure or electricity leakage. If the result is No, it is judged which of normal, degradation, failure and electricity leakage, the measured voltage waveform and current waveform correspond to, and the result is reported and also reported to an electricity household appliance mass retailer and a mail order company at the same time through the Internet.

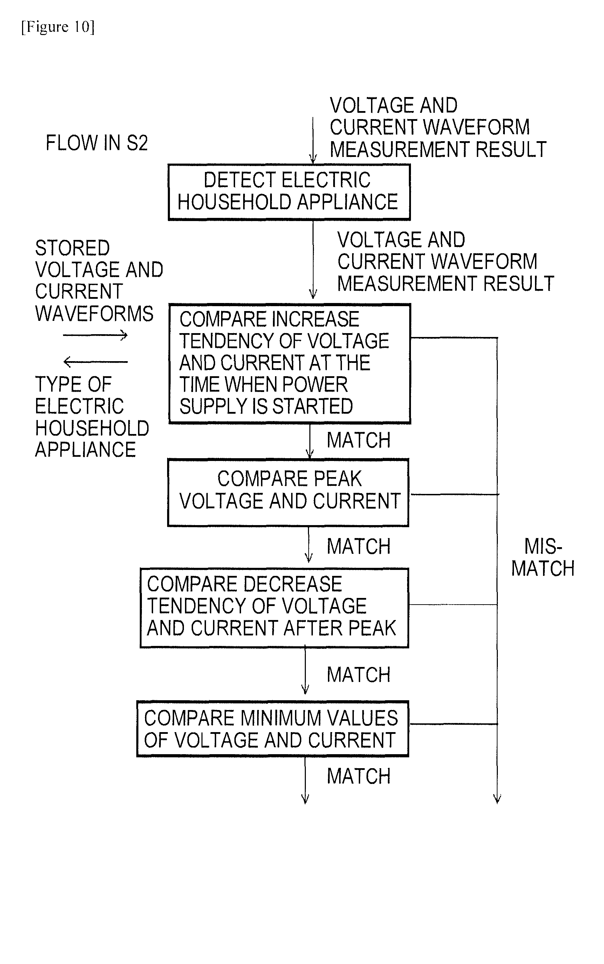

Figure 10 is a diagram for explaining details of the above-described step S2, and the server specifies the electric household appliance by collating the measurement result of the voltage waveform and the current waveform transmitted from the smart tap with the past data stored in the voltage and current waveform DB.

The measured voltage waveform and current waveform are compared with the past voltage waveform and current waveform of the electric household appliance corresponding to the specified electric household appliance, particularly, regarding tendency of change such as increase of a voltage and a current when the power supply is started. If this tendency matches, further, comparison is performed regarding a peak voltage and a peak current.

If the peak voltages and the peak currents match, comparison is performed regarding tendency of decrease of a voltage and a current after the peak.

If the voltages and the currents after the peak also match, comparison is further performed regarding minimum values of the voltage and the current, and if all the features match, it is judged that the electric household appliance operates normally.

However, if the features do not match, it is judged that the electric household appliance degrades, or trouble such as failure and electricity leakage occurs.

It should be noted that this comparison is merely one example, and, instead of the voltage waveform and the current waveform, any one or more of the features including the voltage waveform, the current waveform, the characteristic amount of the voltage waveform, the characteristic amount of the current waveform, and, optionally, a waveform of the power amount and the characteristic amount of the waveform of the power amount may be used as the features for judgment.

Further, the features for comparison may not be the same as those listed in this example, the order of the features is arbitrary, and judgment may be performed using completely different features.

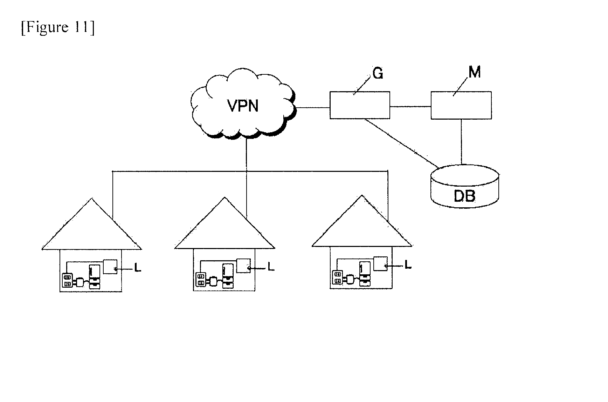

Figure 11 is a diagram illustrating an example where local servers L are provided at a plurality of houses, the local servers at these houses are connected to a global server G via a network such as VPN, and, further, a management server M and a database DB are connected.

In the case illustrated in Figure 11, the electric household appliance remote monitoring system of the present invention transmits the voltage waveform, the current waveform, the characteristic amount of the voltage waveform and the characteristic amount of the current waveform, and optionally, the waveform of the power amount, and the characteristic amount of the waveform of the power amount detected at the smart taps illustrated in the shape of outlets to the local servers L.

The local servers L may transmit the received voltage waveform, current waveform, characteristic amount of the voltage waveform, characteristic amount of the current waveform, and, optionally, a waveform of the power amount and characteristic amount of the waveform of the power amount to the global server G, or the local servers L themselves may judge whether the connected electric household appliance operates normally or degrades, or some abnormality or electricity leakage occurs.

According to the judgment, if all the connected electricity household appliance which is operating normally operates, the local servers L communicate the result.

However, in the electric household appliance remote monitoring system of the present invention, if degradation, abnormality or electricity leakage occurs in the connected electric household appliance, the result should be also reported to the management server M in addition to the user or the owner of the electric household appliance.

In the management server M, electric household appliance information regarding the electric household appliance, such as a date of sale, a manufacturer, model number, product number and a guarantee period of each electric household appliance is stored as a database DB.

Therefore, when abnormality of the electric household appliance is reported to the user and/or the owner, it is possible to report the above-described electric household appliance information stored in the database DB along with information regarding repair, new electric household appliance for upgrading and/or a way of using the electric household appliance.

The user and/or the owner receiving such information can know contact for repair, parts to be repaired, introduction of new electric household appliance and price concerning upgrading, a more efficient way of using the electric household appliance and a way of reducing power consumption of the electric household appliance, or the like, concerning the way of using the electric household appliance and/or electric equipment. That is, it is possible to establish trustful relation between a seller of the electric household appliance such as an electric household appliance mass retailer and a mail order company, and an electric household appliance user side who actually uses the electric household appliance, so that the user can use the electric household appliance without anxiety and save power comfortably.

Further, because the operation state of the electric household appliance is always detected, it is possible to make a database of data such as a usage state of the electric household appliance and a life pattern of the user. It is also possible to statistically extract information regarding usage states of a number of electric household appliance, or remotely confirm living activities by recognizing the usage state of the electric household appliance for each local server, so that it is possible to observe the living conditions ofthe remote place.

### (Example)

A device assuming an embedded outlet illustrated in Figure 7 using four MOSFETs for each slot of the outlet was manufactured and connected to a fan.

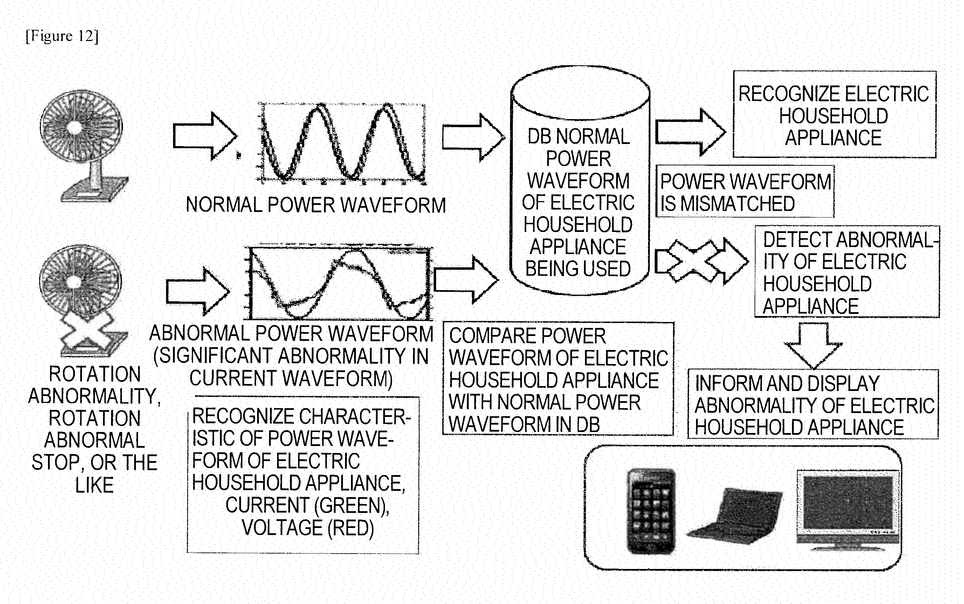

The fan was powered on to start rotation and operation of a motor. Assuming that the fan was continuously used, load was applied to blades of the fan so as to lower rotating speed of the motor. Data at this time is illustrated in Figure 12.

In Figure 12, a current waveform and a power waveform of the fan were measured. While, in a normal state, the waveforms appear as accurate sine waves as illustrated in an upper graph of Figure 12, when load is applied to the blades to simulate a case where abnormality occurs at the motor, apparently, the power waveforms do not appear as sine waves as illustrated in a lower graph.

By comparing these voltage waveforms, it is possible to detect occurrence of abnormality in the connected fan based on a difference in the characteristic amounts such as patterns and peak power.

## Claims

1. An electric household appliance remote monitoring system comprised of a smart tap to which one or two or more power plugs of electric equipment can be inserted, and a server,
the smart tap comprising voltage waveform measuring means and/or current waveform measuring means, communication means, and, optionally, computing means,
the voltage waveform measuring means and the current waveform measuring means measuring a voltage waveform and a current waveform of power to be supplied to one or more pieces of electric equipment via the power plug connected to the voltage waveform measuring means and the current waveform measuring means, the communication means transmitting any one or more of the voltage waveform, the current waveform, a characteristic amount of the voltage waveform, a characteristic amount of the current waveform, and, optionally, a waveform of a power amount and a characteristic amount of the waveform of the power amount to the server provided at a different place from a place where the tap is provided,
the computing means provided optionally obtaining the waveform of the power amount based on the voltage waveform and the current waveform,
the server storing any one or more of the voltage waveform, the current waveform, the characteristic amount of the voltage waveform, the characteristic amount of the current waveform, and, optionally, a waveform of a power amount and a characteristic amount of the waveform of the power amount received from the smart tap, and comparing any one or more of the newly measured and received voltage waveform, current waveform, characteristic amount of the voltage waveform, characteristic amount of the current waveform, and, optionally, a waveform of a power amount and a characteristic amount of the waveform of the power amount with the stored data to judge an operation state of each connected piece of electric equipment and transmit the operation state of the electric equipment.

2. The electric household appliance remote monitoring system according to claim 1, wherein the server is a local server and transmits the judged operation state of the electric equipment to a global server using communication means separately provided.

3. The electric household appliance remote monitoring system according to claim 2, wherein the operation state of the electric equipment is transmitted from the global server to a management server.

4. The electric household appliance remote monitoring system according to claim 2 or 3, wherein information regarding repair or upgrading of the electric equipment and/or a way of using the electric equipment is transmitted to a user and/or an owner of the electric equipment based on the operation state of the electric equipment received at the global server or the management server.

5. The electric household appliance remote monitoring system according to claim 1, wherein the server is a global server, can perform communication with the smart tap via a local server, and transmits the judged operation state of the electric equipment to the local server.

6. The electric household appliance remote monitoring system according to claim 5, wherein any one or more of the voltage waveform, the current waveform, the characteristic amount of the voltage waveform, the characteristic amount of the current waveform, and, optionally, the waveform of the power amount and the characteristic amount of the waveform of the power amount, and/or the judged operation state of the electric equipment is transmitted from the global server to a management server.

7. The electric household appliance remote monitoring system according to claim 2 or 3, wherein information regarding repair or upgrading of the electric equipment and/or a way of using the electric equipment is transmitted to a user and/or an owner of the electric equipment based on any one or more of the voltage waveform, the current waveform, the characteristic amount of the voltage waveform, the characteristic amount of the current waveform, and, optionally, the waveform of the power amount and the characteristic amount of the waveform of the power amount received at the global server or the management server, and/or the judged operation state of the electric equipment.
